Europäisches Patentamt

(19) European Patent Office

Office européen des brevets

(11) Publication number: **0 038 697**

**B1**

(12) **EUROPEAN PATENT SPECIFICATION**

(45) Date of publication of patent specification: **12.12.84**

(21) Application number: **81301732.4**

(22) Date of filing: **21.04.81**

(51) Int. Cl.³: **H 01 L 27/14, H 01 L 29/36, H 04 N 3/14**

(54) Semiconductor image sensor.

(30) Priority: **22.04.80 JP 54001/80**
**06.05.80 JP 60316/80**

(43) Date of publication of application:
**28.10.81 Bulletin 81/43**

(45) Publication of the grant of the patent:
**12.12.84 Bulletin 84/50**

(84) Designated Contracting States:
**BE DE FR GB NL**

(56) References cited:
**EP-A-0 012 029**
**FR-A-2 376 513**
**GB-A-1 259 069**
**GB-A-1 491 304**
**US-A-4 011 442**

**IEEE TRANSACTIONS ON ELECTRON
DEVICES, vol. ED-26, no. 12, December 1979,
New York, J.I. NISHIZAWA et al. "Static
induction transistor image sensors", pages
1970 to 1977**

(73) Proprietor: **SEMICONDUCTOR RESEARCH
FOUNDATION
Kawauchi
Sendai-shi Miyagi 980 (JP)**

(72) Inventor: **Nishizawa, Jun-ichi.
No. 6-16 Komegafukuro 1-chome
Sendai-shi Miyagi-ken (JP)**
Inventor: **Ohmi, Tadahiro
No. 2-1-17-301 Komegafukuro
Sendai-shi Miyagi-ken (JP)**
Inventor: **Tamamushi, Takashige
No. 3-8 Tsunogoro 1-chome
Sendai-shi Miyagi-ken (JP)**

(74) Representative: **Overbury, Richard Douglas et al
HASELTINE LAKE & CO Hazlitt House 28
Southampton Buildings Chancery Lane
London WC2A 1AT (GB)**

Courier Press, Leamington Spa, England.

## Description

### Field of the invention

The present invention relates generally to a semiconductor image sensor, according to the first part of Claim 1. Further, the invention pertains to a method for operating such a semiconductor image sensor. Such a sensor is known from IEEE Transactions on Electron Devices Vol. ED-26, Dec. 1979. No. 2, pages 1970—1977.

### Description of the prior art

Solid-state image sensors are roughly divided into the CCD and the MOS type. In the CCD image sensor, signal charges are stored in a potential well induced by an electric field in a semiconductor region beneath an MOS capacitor electrode, and their readout is accomplished by multiple transfers through such induced potential wells to an output circuitry. But in the MOS image sensor, the signal charge is collected by a photodiode formed by diffusion or ion implantation, and the readout is carried out by a single transfer from the photodiode via an adjoining MOSFET to a video-out circuitry.

These differences in structure, manufacture and readout result in wide differences in performances at high and low light levels and in image clarity. At low light levels, the minimum light that can be resolved by the image sensor largely depends on the light collecting ability of the image sensor, that is, the efficiency with which the image sensor can collect the light incident thereon, as well as noise introduced by the sensor cell and its associated circuitry.

In general, the MOS image sensor converts light to signals more efficiently than the CCD; this results from the differences in the amount of light reflected from the imaging surface of each device and in the aperture efficiency. The CCD image sensor has an array of two- or three-layer electrodes on the imaging surface, which absorb much light, so that the CCD image sensor collects less light than does the MOS image sensor.

Two common techniques are used to illuminate the semiconductor substrate in monolithic image sensors-front and back illumination.

Either technique could be used with either CCD or MOS image sensors but the front illumination is not suitable for use with the CCDs because most CCD structures have an uneven front and charge transfer electrodes thereon which reduce the light collecting area. It is apparent that MOS structures have not a completely flat front, either, and that when they are illuminated from the front the amount of light reflected from the imaging surface is greater than in the case of a completely flat front surface.

Unfortunately, back lighting introduces a fabrication problem—a requirement for a thin substrate and performance limitations on the spatial resolution. In the case of the back illumination, the substrate must be made very thin so that light-generated carriers (which are usually generated within about 5 $\mu$m of the semiconductor surface for visible light in the case of a silicon substrate) may be efficiently collected and stored in a depletion layer beneath capacitor electrodes on the front side. The thinnest substrate that can be fabricated has a thickness of about 25 $\mu$m. This means that device elements cannot be spaced less than 25 $\mu$m apart; namely, since the carriers generated by back lighting in the substrate spread by diffusion, it is necessary from the viewpoint of the spatial resolution that the thicker the substrate becomes, the more MOS electrodes on the front be spaced apart. This is a restriction that limits the potential resolution of back-illuminated CCDs. This limitation on the element spacing is especially damaging for large-capacity image sensors having a large number of picture elements because it means that each picture element covers a relatively large area, resulting in a large silicon substrate being needed.

Clearly, front illumination is desirable for simple structures to give good resolution. MOS image sensors, fortunately, have a silicon oxide film layer covering the semiconductor substrate, and this transparent oxide film acts as an optical coating that matches the optical impedance of the silicon to the impedance of air.

Some CCD image sensors also have been built with polycrystalline silicon electrodes that can be illuminated from the front, but these polycrystalline structures provide poor impedance matches with the oxide film beneath, which causes reflection at the polysilicon-oxide interface. These mismatches create interference patterns in the surface reflection, resulting in a decrease in the signal photocurrent output.

Whether the image sensor array is illuminated from the front or the back, noise introduced into the video signal by the image sensors and associated circuitry is the greatest factor that limits operation at low light levels. The noise, which masks small output signals at low light levels, comes from mismatches in parasitic capacitances and thermally generated carriers. Moreover, CCDs suffer noise from transfer losses.

In MOS image sensors, there is posed a problem by capacitive coupling noise that results from mismatches between parasitic gate-source and gate-drain MOS capacitance of transistors in the scanning circuit and photodiodes and video output port (with which these capacitances are in series).

When these MOS transistors are turned on or off, there is a corresponding voltage spike on the analog photosignal line (video line) being switched. Although these spikes may be reduced by low-pass filtering, because they

occur at twice the maximum video frequency, they cannot be eliminated completely.

The variation in the magnitude of these spikes throughout the MOS photoarray gives rise to fixed-pattern noise in the video passband. This type of noise can be eliminated by low pass filters. Fortunately, the variation in the noise is small compared to the absolute magnitude of the spikes.

Spike noise, as observed at the sensor output, is referenced to an equivalent noise voltage across the capacitance of the photosensing element, for example, in a representative 512-element line sensor. Values of noise range from about $1 \times 10^{-3}$ to $0.5 \times 10^{-2}$ volts, well within practical operating levels. The saturated output signal referred to the photodiode is typically 5 volts, resulting in dynamic ranges of 100 to 1 and more.

While CCDs are not affected by the fixed-pattern noise from the spikes in switching transistors, they have fixed-pattern noise resulting from capacitance between clock lines and the output lines. Luckily, these noise pulses are all the same height and can be filtered out by low-pass filters, but the filters consume power and occupy space.

The best method of reducing this capacitive coupling noise is to fabricate video preamplifiers on the same image sensor chips. The noise is thereby reduced because the magnitude of the parasitic coupling capacitance may be made smaller for amplifiers on the same chips than for off-the-chip amplifiers.

Fixed-pattern noise in both MOS image sensors and CCDs can also come from thermal effects (thermally generated carriers). The CCD image sensors, however, are more susceptible to thermal effects than are the MOS image sensors because the surface of the CCDs is not in equilibrium, which causes thermal imbalance.

This form of noise is most troublesome at illumination levels below 10 $\mu$W/cm$^2$ and for light-integration periods longer than 100 msec for typical image sensors because the noise comprises a significant portion of the dark current at these levels and represents the ultimate operating limitation.

But with the CCD image sensors, transfer-loss noise is more damaging than the fixed-pattern noise. This reduces the exposure range of the CCD image sensors and consequently decreases the contrast that they can detect.

Now, the conventional image sensors will be evaluated from the standpoints of (1) dynamic range, (2) sensitivity, (3) noise and (4) image clarity, which are important performance criteria. In ordinary image sensors, the lower limit of the dynamic range depends on the spike noise resulting from the aforesaid capacitive coupling and the thermal noise (dark-current noise), and the upper limit is, in the MOS image sensors, the bias voltage of the photodiodes and, in the CCDs, the depth of the potential well (both of which are about 5V). In terms of (2) sensitivity, letting the capacitance for storing carriers and the amount of charges being stored be represented by $C_S$ and Q, respectively the stored voltage is given by $Q/C_S$. This photodiode voltage is capacitively divided by the output line capacitance $C_B$ and output voltage is represented as the following voltage:

$$\frac{C_S}{C_B + C_S} \cdot \frac{Q}{C_S} = \frac{Q}{C_B + C_S}$$

where $C_B$ is the capacitance of the output line. That is, the stored voltage $Q/C_S$ is divided by the sum of the capacitance $C_B$ of the output line and the storage capacitance $C_S$ and the output voltage is reduced to $Q/(C_B + C_S)$. Further, it is a matter of course that the influence of noise must be taken into account when discussing the sensitivity.

Moreover, the sensitivity depends on the amount of light that is sensed by sensor cells, that is, their light collecting ability; the problem of sensitivity should be considered from the view points of unevenness of the illuminated surface and the impedance matching too. The most critical is the spike noise that results from the capacitance coupling and ranges from $10^{-3}$ to $0.5 \times 10^{-2}$ V and defines the lower limits of the dynamic range. The dark-current noise poses a problem as the light integration period becomes longer (for example, in excess of 100 msec) at low light levels below 10 $\mu$W/cm$^2$ and it limits the operational range of the image sensor.

In terms of (4) spatial resolution, the smaller the cell area, the better. In practice, however, for example, the back illumination type CCD image sensors must be designed so that the electrodes are spaced more than the thickness of the substrate apart. Further, since the voltage $Q/C_S$ stored in the storage capacitance $C_S$ of the image cell is read out in the form of

$$\frac{C_S}{C_B + C_S} \cdot \frac{Q}{C_S} = \frac{Q}{C_S + C_B}$$

reduced by the capacitive division with the output line $C_B$, operational amplifiers with high sensitivity and low noise are needed and a minimum area of the image cells is limited which depends on the sensitivity of the operational amplifiers and the noise level. The light integration period which is determined by a reciprocal of the frame frequency gives temporal resolution (time-like image clarity).

The CCD image sensors have such a serious drawback that since information is transferred through the cell structure, if even one of the image cells is defective the signal intensity of all image cells preceding the defective one are subject to changes. Accordingly, all the cells must be fabricated defect-free but such cells are difficult to manufacture with good yield.

In contrast thereto, the MOS image sensor which can be read out by the random access system is free from the abovesaid defect resulting from the charge transfer. Since the MOS image sensor has the arrangement that charges stored in photodiodes are read out, however, it is difficult to raise the sensitivity and an amplifier with very low noise and high sensitivity is required.

The present inventors have proposed a novel image sensor which incorporates therein a hook structure having an amplifying function with a view of removing the aforesaid defects of the prior art CCD and MOS image sensors, in particular, increasing the light detecting sensitivity. This novel image sensor excels the CCD and MOS image sensors in the capability of highly sensitive random access of light information.

IEEE Transactions on Electron Devices, Vol. ED-26, No. 12, December 1979, pages 1970 to 1977, in an article by the inventors entitled 'Static Induction Transistor Image Sensors' discloses image sensors having hook structures for detecting radiant energy input information, and readout and refresh transistors according to the first part of Claim 1.

The inventors now make further proposals concerning operating characteristics and optimum device design conditions.

An aim of the present invention is to provide a semiconductor image sensor in which the impurity concentration in each region of the hook structure, the impurity profile and the thickness of each region are selected so that the light detecting hook operation may be achieved under optimum conditions.

An aim of the present invention is to provide a semiconductor photosensor in which materials used to form each region of the hook structure is selected so that the light detecting hook operation may be achieved under optimum conditions.

An aim of the present invention is to provide a high-sensitivity semiconductor image sensor which has an excellent light collecting ability.

An aim of the present invention is to provide a semiconductor image sensor in which the relationships of electrostatic capacitances in respective parts of the sensor are selected so that a high readout voltage may be stored in the hook structure and readout with high sensitivity.

An aim of the present invention is to provide a method of operating a semiconductor image sensor which permits almost perfectly reading-out of the time-integrated value of incident light thereon.

In order to achieve the above aims according to the present invention there is provided a semiconductor image sensor, comprising a radiant energy input information detecting hook structure consisting of first to fourth regions formed on a semiconductor substrate from a main surface thereof towards the inside thereof, the first region being a conductive region for receiving radiant energy, the second region having a high resistivity, the third region being of a first conductivity type and having a low resistivity, the fourth region being of a second conductivity type, reverse from the first conductivity type, and having a low resistivity, said image sensor further comprising a readout transistor and a refresh transistor, the readout transistor using the fourth region as one of its main electrodes, and the refresh transistor using the third region as one of its main electrodes, characterised in that the third region has an impurity density in the range of about $10^{15}$ to $10^{18}$ cm$^{-3}$ and a thickness in the range of about 0.2 $\mu$m to 3 $\mu$m, and that the fourth region has an earth capacitance larger than a junction capacitance of a pn junction formed between the fourth region and the third region.

According to a further aspect of the present invention there is provided a method of operating such a semiconductor image sensor provided with a radiant energy input information detecting hook structure, a readout transistor and a refresh transistor, in which the readout transistor is rendered conductive a plurality of times in the time interval between a conductive state of the refresh transistor and the next conductive state thereof, thereby permitting readout of the time-integrated value of the input radiant energy.

An embodiment of the present invention can provide a semiconductor image sensor which is of wide dynamic range, high sensitivity, low noise and high image clarity, as compared with the conventional CCD and MOS image sensors, by selecting optimum design conditions based on experimental and analytical results obtained on the image sensor provided with the hook structure.

Reference is made, by way of example, to the accompanying drawings, in which:—

Figure 1A is a partial sectional view schematically showing principal parts of a semiconductor image sensor embodying the present invention;

Figure 1B shows a schematic circuit diagram of one cell of the image sensor depicted in Figure 1A;

Figures 1C to 1E are graphs illustrating characteristics of an image sensor embodying the present invention;

Figure 2A is a partial sectional view schematically illustrating principal parts of another image sensor embodying the present invention;

Figure 2B is an equivalent circuit of one cell of the image sensor depicted in Figure 2A;

Figures 3A and 3B are, respectively, a plan view and a sectional view illustrating principal parts of another image sensor embodying the present invention;

Figure 4A is a circuit diagram showing the connections of six cells of the image sensor depicted in Figures 3A and 3B;

Figure 4B is a block diagram illustrating an example of an image sensor system in which cells of the image sensor shown in Figures 3A and 3B are assembled into an area color image sensor;

Figure 5A is a block diagram illustrating an example of an image sensor system in which cells of the image sensor shown in Figures 3A and 3B are assembled into an area color image sensor;

Figure 5B is a circuit diagram showing the connections of four cells of the image sensor depicted in Figure 5A;

Figures 6A to 6D are, respectively, a plan view, a sectional view, another sectional view, and a schematic circuit diagram illustrating principal parts of another image sensor embodying the present invention;

Figure 7 is a partial sectional view schematically showing a front illuminated type image sensor in accordance with an embodiment of the present invention;

Figure 8 is a partial sectional view schematically showing a front illumination type image sensor without refresh transistor;

Figure 9A is a partial sectional view schematically showing a back illumination type image sensor in accordance with another embodiment of the present invention;

Figure 9B is a schematic circuit diagram of one cell of the image sensor depicted in Figure 9A;

Figure 10 shows a series of waveforms explanatory of the operation of an image sensor embodying the present invention; and

Figure 11 is a graph illustrating characteristics of an image sensor embodying the present invention.

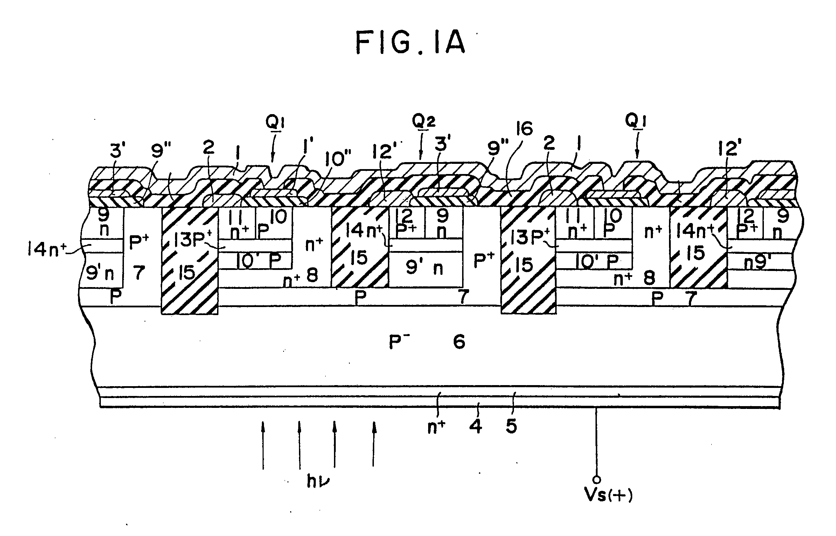

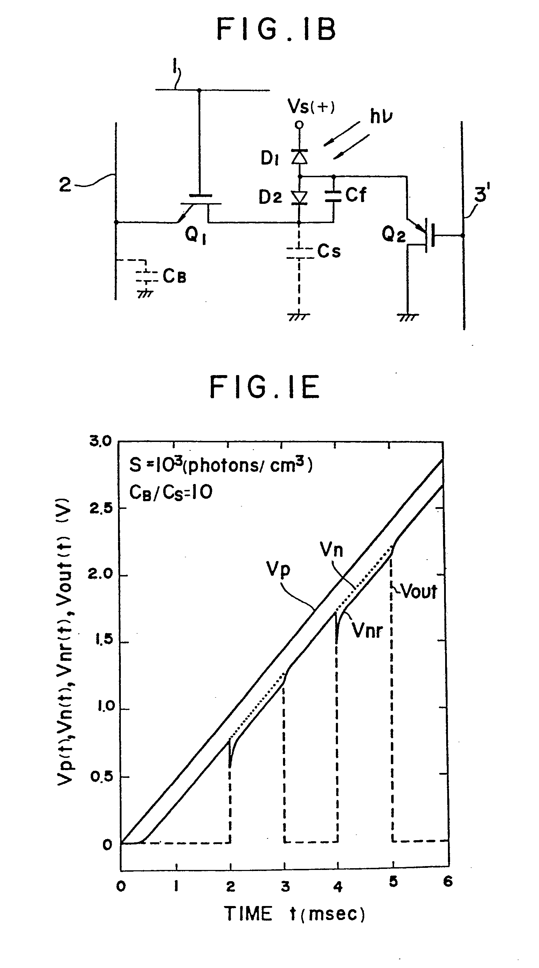

Figures 1A and 1B are respectively a sectional view and a schematic circuit diagram of a cell of the image sensor of an embodiment of the present invention which is provided with the photosensing region composed of a hook structure, an n-channel MISSIT (Metal-Insulator-Semiconductor Gate Static Induction · Transistor) $Q_1$ for readout use and a p-channel MISSIT $Q_2$ for refresh use.

In Figures 1A and 1B, reference numeral 1 indicates a word line, which is formed of a metal such as aluminum, tungsten or molybdenum, or polysilicon or silicide and which is connected to a gate electrode 1' of the n-channel transistor $Q_1$; 2 designates a bit line which is connected to an $n^+$ source region 11 of the transistor $Q_1$ and which is formed of polysilicon or a silicide of tungsten, tantalum or molybdenum; 3' identifies a gate electrode of a p-channel MISSIT $Q_2$ for refresh use, serving as a refresh line; 4 denotes a transparent electrode which is biased by the power source voltage $V_s(+)$ and connected to an $n^+$ region 5. An $n^+$ region 8 serves as the drain of the transistor $Q_1$ and a region from which electrons flow out in response to a light input and are charged positive, storing therein light information as a voltage. A p region 7 is a region in which holes generated by pair creation due to the optical irradiation in region 6 are stored and which serves as a source region of the refresh transistor $Q_2$. A p region 10 and an n region 9 are channel regions of the transistors $Q_1$ and $Q_2$ respectively and they are covered with gate insulating films 10'', 9'' for example, $SiO_2$ or $Si_3N_4$. A $p^+$ region 13 and an $n^+$ region 14 are buried regions provided for limiting the thicknesses of depletion layers in the channel regions so as to avoid that voltage information stored in the $n^+$ region 8 and the p region 7 varies under the influence of $\alpha$ rays or the like and to achieve an excellent normally OFF characteristic with a short channel MOS gate structure. Accordingly, regions 10' and 9' (shown as p and n regions) are unnecessary for the operation of the transistors $Q_1$ and $Q_2$ and may be filled with an insulator, too. Specifically, the SIMOX (Separation by Implanted Oxygen) techniques for providing an insulating region by the ion implantation of oxygen or nitrogen, grapho-epitaxy techniques and laser annealing techniques are suitable in terms of manufacturing process. Further, the regions 13 and 14 may also be formed of an insulator or non-doped polysilicon to ensure that the transistors $Q_1$ and $Q_2$ exhibit the OFF characteristic; in this case, the semiconductor regions 10, 9, 11 and 12 overlying the regions 13 and 14 are rendered into single crystal through the use of the laser anneal, or the like. In the case where the channel length of the MOS structure is not made so short, it is also possible, of course, that the regions 10, 10' and 13 and the regions 9, 9' and 14 are formed as the p region 10 and the n region 9, respectively. Reference numeral 15 indicates isolation regions.

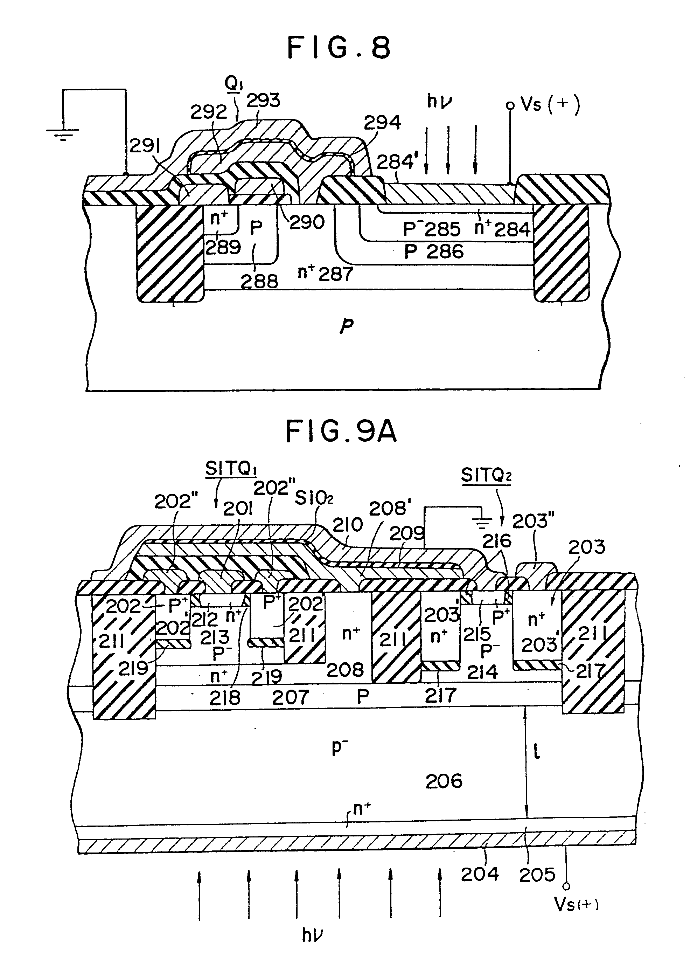

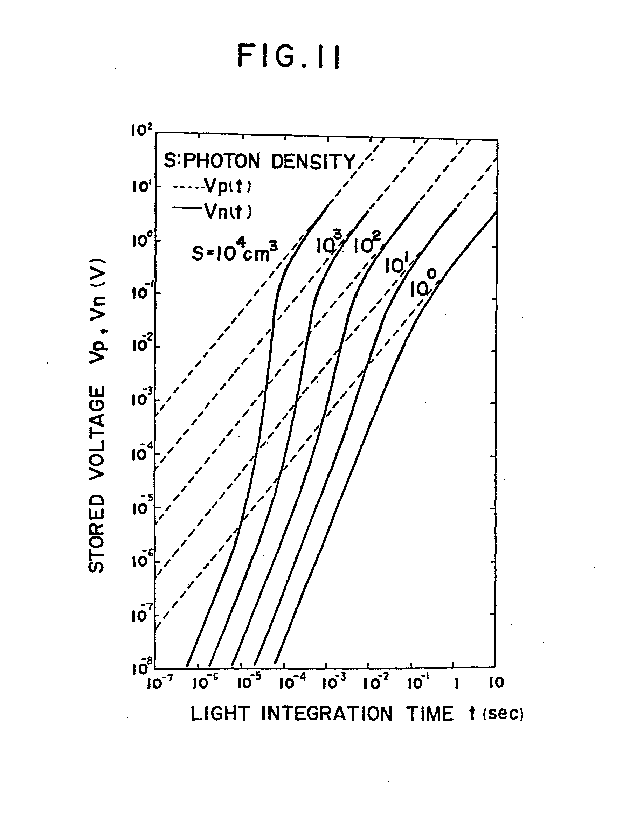

In the embodiment of Figure 1A, a major storage capacitor $C_S$ and an earth line are not illustrated for the sake of brevity but it should be understood that the semiconductor image sensor of the present invention includes the major storage capacitor of an $Al-SiO_2$-polysilicon structure and the earth line, as described later (for example, in connection with Figures 8 and 9A) (see IEEE Transactions, on Electron Devices, Vol. ED-26, No. 12, 1979, P 1975, Figure 11).

A brief description will be given of the impurity concentrations and sizes of the abovesaid regions.

The impurity concentrations are about $10^{18}$ to $10^{21}$ cm$^{-3}$ in the $n^+$ region 5, about $10^{18}$ to $10^{21}$ cm$^{-3}$ in the $n^+$ region 8, about $10^{18}$ to $10^{21}$ cm$^{-3}$ in the $n^+$ region 11, about $10^{16}$ to $10^{18}$ cm$^{-3}$ in the $n^+$ region 14, about $10^{15}$ to $10^{18}$ cm$^{-3}$ in the p region 7, about $10^{18}$ to $10^{21}$ cm$^{-3}$ in the $p^+$ region 12, about $10^{16}$ to $10^{18}$ cm$^{-3}$ in the $p^+$ region 13, about $10^{14}$ to $10^{16}$ cm$^{-3}$ in the n regions 9 and 9', and about $10^{14}$ to $10^{16}$ cm$^{-3}$ in the p regions 10 and 10'. The impurity concentration of the region 6 is determined in relation to its thickness l. When the voltage

$V_s(+)$ is applied, the region 6 is exposed to an electric field which depletes its entire area and permits holes to flow throughout the depleted region 6 at high velocity. The thickness l of the region 6 is determined in relation to the spatial resolution. The thickness of the $n^+$ region (5) is closely related to color sensitivity. The penetration depths of light having wavelengths of 700, 500 and 440 nm (7000, 5000 and 4400 Å) into silicon are approximately 5, 1 and 0.5 $\mu$m, respectively. Accordingly, for enhancement of sensitivity to blue and purple, it is preferred to form the $n^+$ region 5 as thin as possible, for example, around 0.5 $\mu$m or less. The sensitivity to blue and purple can further be increased by removing the $n^+$ region 5 to provide a heterojunction between the region 6 and the transparent electrode 4. The transparent electrode 4 is formed, for instance, using $In_2O_3$, $SnO_2$ or low resistivity polysilicon.

The thickness of the p buried region 7 ranges about 0.2 to 3 $\mu$m. It is desirable to minimize the thickness of the region 7 unless it is depleted but, in view of reduction in yield resulting from difficulty in manufacture, it is preferred that the region 7 be 0.2 $\mu$m or more in thickness. The reason for which the region 7 is formed to a thickness of 3 $\mu$m or less is to facilitate an efficient outflow of electrons from the $n^+$ region 8. The depth of the $n^+$ buried region 8 is about 0.5 to 3 $\mu$m. The thicknesses of the gate insulating films 9″ and 10″ are, preferably, in the range of 10 to 100 nm (100 to 1000 Å). When the working voltage is low, these films may be thinner than 10 nm (100 Å).

A description will be given of the operation of this embodiment. The optical input, which has passed through the transparent electrode 4 (formed of $SnO_2$, $In_2O_3$ or doped polysilicon) applied with the fixed bias voltage $V_s(+)$ generates electron-hole pairs in the hook structure made up of the $n^+$ region 8, the p region 7, the $p^-$ region 6 and the $n^+$ region 5, in particular, in the high resistivity layer 6 near the $n^+$ layer 5. By the voltage $V_s(+)$, an electric field is applied to the high resistivity region 6 to completely deplete it over the entire area thereof, permitting holes to flow substantially throughout it at a saturated velocity. In the case where the spatial resolution need not be so high, the field intensity of the high resistivity region 6 may be made lower. The electrons thus generated are all absorbed into the $n^+$ region 5, attracted by the bias voltage $\cdot V_s(+)$, whereas the holes are stored in the p region 7 flowing through the high resistivity region 6. This is because the high resistivity region 6 is substantially entirely depleted by the bias voltage $V_s(+)$ and because a high intensity field is applied over the entire thickness l of the high resistivity region 6. When the holes are accumulated in the p region 7, it is charged positive; namely, the potential barrier height for electrons in the $n^+$ region 8 is lowered, permitting the electrons to flow out from the $n^+$ region 8 towards the substrate across the thin p region 7. As a result of this, electrons are depleted in the $n^+$ region 8 which is held floating relative to an earth line (not shown) via an electrostatic capacitance $C_s$, the $n^+$ region 8 is charged positive and consequently its earth voltage $V(t)$ increases with the lapse of time. This increasing voltage value $V(t)$ is read out by the readout transistor $Q_1$ onto the signal output line 2 at a desired time.

The voltage $V(t)$ of the $n^+$ region 8 increases with the optical irradiation time; this is because the amount of holes accumulated in the p region 7 increases as the optical irradiation proceeds. A sufficiently long period of time after the start of optical irradiation, the voltage $V(t)$ assumes a value which is approximated by the following equation:

$$V(t) \approx \int_0^t \frac{cq}{C_f} S(t)dt \qquad (1)$$

where $C_f$ is the junction capacitance of the pn junction formed between the p region 7 and the $n^+$ region 8, c is light velocity, q is a unit charge and $S(t)$ is the photon density (photons/cm³) which is a function of time.

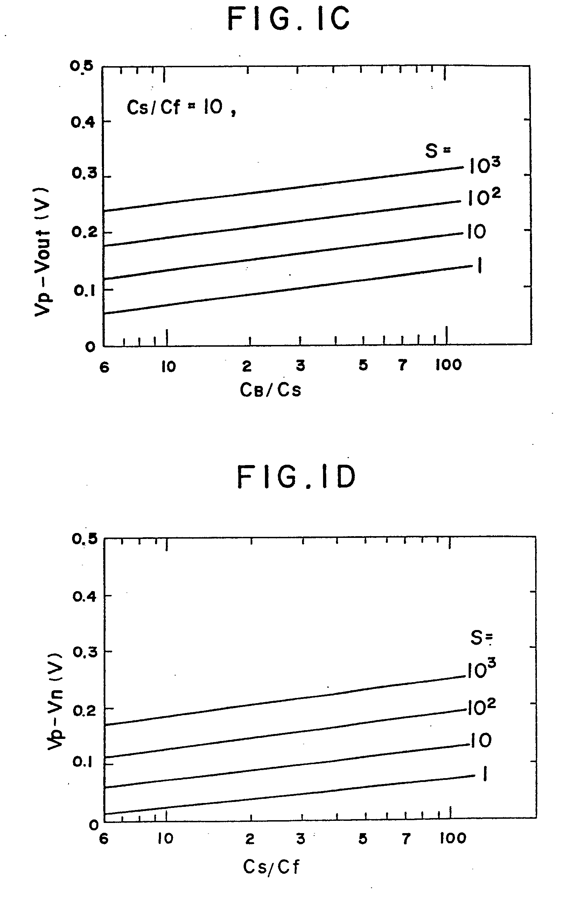

Equation (1) is important in that the voltage $V(t)$ proportional to the time-integrated value of the photon density of the optical input is obtained, and in that the voltage $V(t)$ independent of the storage capacitance $C_s$ of the $n^+$ region 8 is stored therein. For a better understanding of the latter feature, reference be made to Figure 1C. Figure 1C shows the relationships between $C_B/C_s$ and $V_p-V_{out}$ using the value of the photon density S as a parameter, where $C_B$ is the capacitance of the signal output line, $V_p$ is the voltage of the p region 7 and $V_{out}$ is an output voltage value read out on the signal output line.

A voltage $V_{out}(t)$ which occurs on the signal output line 2 upon conduction of the transistor $Q_1$ by opening the address line (word line) 1, is not the voltage obtained by the division of the capacitances $C_s$ and $C_B$:

$$\frac{C_s}{C_s+C_B} V(t)$$

Letting the time constant of the transistor $Q_1$ which is determined by an on-resistance R and the capacitance $C_B$ be represented by $R_B C_B$, the abovesaid voltage is given by

$$V_{out}(t) = V(t)(1-e^{-t/R\,C_B}) \qquad (2)$$

Accordingly, the voltage on the signal output line 2 is still $V(t)$ if the time constant is ignored. This means that a sensor has incorporated therein the time variable voltage source $V(t)$ proportional to the time integration of the optical input. In the prior art MOS and CCD image sensors, the readout voltage is capacitively divided and, letting the charges stored by optical irradiation in the storage region be represented by Q, the readout voltage is given by

$$\frac{C_S}{C_S+C_B} \cdot \frac{Q}{C_S} = \frac{Q}{C_S+C_B}$$

as referred to previously. In contrast thereto, in the image sensor of the present invention the readout voltage is $Q/C_f$ almost independent of the capacitances $C_S$ and $C_B$. In other words, the sensitivity of the readout voltage is substantially $(C_S+C_B)/C_f$ times higher than that obtainable with the conventional sensors. The sensitivity is readily improved 10 to 100 times as high as that in the past.

In the conventional image sensors, the voltage of the storage region is read out by the division of the storage capacitance and the signal readout line capacitance, whereas in the image sensor of the present invention, the stored voltage is read out substantially as it is. This difference will be described in more detail. In the prior art system, upon conduction of the readout transistor, the charges stored in the storage region decrease. Its value is as follows:

$$\frac{C_S}{C_B+C_S}V(t)$$

Usually, $C_B \gg C_S$ and the readout voltage is greatly decreased by the capacitance division. Therefore, a stacked capacitor structure which maximizes the capacitance $C_S$ with the smallest possible cell has been employed by preference.

On the other hand, in the image sensor of the present invention, for example, depicted in Figure 1A when the readout transistor is conducted, electrons flow into the $n^+$ region 8 from the $n^+$ region 11. In the prior art system, the amount of electrons lacking decreases by the amount of electrons having flowed in the region. In the image sensor of the present invention, however, when the electrons flow into the $n^+$ region 8 to decrease the amount of electrons lacking therein, and reduce the positive voltage, the junction between the $n^+$ region 8 and the p region 7 is deeply biased in the forward direction and the electrons in the $n^+$ region 8 flow out therefrom towards the high resistivity region across the p region 7, resulting in the voltage relationship between the $n^+$ region 8 and the p region 7 becoming nearly equal to the original relationship. In short, the electrons that flowed from the $n^+$ region 11 into the $n^+$ region 8 are absorbed into the $n^+$ region 5 via the p region 7 and the high resistivity region 6. Therefore, the readout voltage becomes substantially equal to the voltage of the $n^+$ storage region 8, no matter how large the signal output line capacitance $C_B$ may be.

In the image sensor of the present invention, the readout voltage is given substantially by $Q/C_f$. The junction capacitance $C_f$ decreases with a decrease in the cell area. If a lens provided in front of the optical input receiving surface has a resolving power large enough to sufficiently collect the incident light, then the stored charge Q hardly decreases with a decrease in the cell area and only the junction capacitance $C_f$ decreases, so that the readout voltage increases more and more. This presents a striking contrast to the conventional image sensors in which a decrease in the cell area causes a decrease in the readout voltage.

The above indicates that the storage capacitance $C_S$ of the $n^+$ region 8 need not always be large in relation to the signal output line capacitance $C_B$, but in relation to the junction capacitance $C_f$, it is preferred that the capacitance $C_S$ is large. Figure 1D shows the relationships between $C_S/C_f$ and $V_p-V_n$ using the photon density as a parameter. In Figure 1D, $V_p$ is the voltage of the p region 7 and $V_n$ is the voltage of the $n^+$ region 8. As is evident from Figure 1D, $V_p-V_n$ increases monotonically with an increase in $C_S/C_f$. Accordingly, for enhancement of the sensitivity, it is desirable that $C_S/C_f$ is as large as possible, but from a tradeoff with a difficulty in fabrication, $C_S/C_f \gtrsim 3$ is a proper range for realizing the image sensor of the present invention.

Figure 1E shows an example of variations in the voltage $V_p(+)$ of the p region 7, the voltage $V_n(t)$ of the $n^+$ region 8 and the signal output voltage $V_{out}(t)$ with time in the case where two readout operations are carried out during the same optical input period. In Figure 1E, $V_{nr}(t)$ is the voltage of the $n^+$ region 8 in the readout process. The voltage $V_p(+)$ of the p region 7 increases linearly with time independently of the readout operation. This means that holes stored in the p region 7 are not affected by the readout operation. On the other hand, the voltage $V_n$ of the $n^+$ region 8 increases with time keeping a constant difference with the voltage $V_p$ but in the readout process, undergoes such a transient change as indicated by $V_{nr}$. This is because during the readout process electrons flow into the $n^+$ region 8 to temporarily lower the voltage thereof.

The refresh transistor $Q_2$ in Figure 1 remains in the OFF state in the optical irradiation period, during which a gate of the transistor $Q_1$ is turned-on by sampling pulses $S_1$ $S_2$,...$S_n$ of a sampling period $t_s$, by which the continuously changing integrated output V(t) of the optical input in formation S(t) is provided on the bit line at time intervals divided by the sampling period $t_s$. The holes stored in the p region 7 are refreshed by the transistor $Q_2$ at intervals of $T_s$.

The thickness of the p region 7 is selected to be smaller than the diffusion length of electrons which are injected thereinto from the $n^+$ region 8. It is desirable that the thickness of the $n^+$ region 8 is larger than the diffusion length of holes. The holes stored in the p region 7 become extinct mainly in the thermal generation-recombination process but some of them flow into the $n^+$ region 8 due to diffusion and disappear there. Since the actual optical information is determined by the of holes stored in the p region 7, it is not desirable that the holes flow into the $n^+$ region 8. In practice, the $n^+$ region 8 is charged positive as the electrons therein are depleted, so that the holes are not injected thereinto in quantities. The potential of the junction between the $n^+$ region 8 and the p region 7 is slightly lower than a diffusion potential in thermal equilibrium by an amount dependent on the difference in the effective mass between the electrons and the holes and becomes a forward bias. Further, as the voltage with which the $n^+$ region 8 is charged positive increases, a conduction channel is likely to be formed between the $n^+$ region 8 and the source region of the transistor $Q_1$ and the holes of the p region 7 are also liable to fly into the channel region.

In order to prevent that the holes stored in the p region 7 flow out into the $n^+$ region 8, it is preferred, according to the present invention, to form the $n^+$ region of a wide band gap material of which for example, doped SIPOS (Semiconductor Insulating Polycrystalline Silicon). The SIPOS for the $n^+$ region 8 consists of 55.4% of silicon, 44% of oxygen and 0.6% of phosphorus. The band gap of this material is 1.5eV, which is larger than that of silicon; therefore, it prevents the flowing thereinto of the holes from the p region 7 and raises the efficiency of electron injection from the $n^+$ region 8 as well. Moreover, the use of the SIPOS extremely improves the response speed of the hook structure composed of the regions 8, 7, 6, and 5 to the optical input, that is, the frequency characteristic of the hook structure.

In the image sensor of the present invention the optical information, time-divided by the sample period $t_s$, is read out non-destructively. The time-like image clarity, i.e. the temporal resolving power for the readout is determined by the frequency characteristic of an optical sensing portion by the hook structure, the frequency characteristic of the readout transistor and the parasitic capacitance $C_B$ of the signal output line. The frequency characteristic in the hook structure part is improved by forming the $n^+$ region 8 of the doped SIPOS or the like to provide a wide band gap and reducing the thickness of the p region 7.

In Figure 1, the transistors $Q_1$ and $Q_2$ are described to be MISSITs but may also be J-SITs, MOSFETs, MISFETs or J-FETs, or any combination of them. As for the readout transistor, it is desirable to employ a SIT which exhibits a linear current-voltage characteristic, not a conventional device of a saturated current-voltage characteristic. This is because in the present invention the dynamic range is enlarged to increase the linearity of the output voltage. In the conventional image sensors, the optical irradiation period (determined by the frame frequency) provides the temporal resolution, whereas in the present invention, the temporal resolution is raised corresponding to increased sensitivity.

Also in the spatial resolution, the image sensor of the present invention is far more excellent than the prior art image sensors. Since the image sensor of the present invention is designed to satisfy the following equation (3):

$$V_s(+) \gtrsim \frac{qNl^2}{2\varepsilon}, \quad V_s \gtrsim lE_s \qquad (3)$$

where $\varepsilon$ is the dielectric constant, q is the elementary charge, N is the impurity concentration and $E_s$ is the electric field at which the carriers reach the saturated velocity, so that when holes of a $\delta$-function-like distribution $n_0$ (x, y) (the x-axis is parallel to the main surface of the substrate and the y-axis is perpendicular to the x-axis) occur in the junction interface between the i region 6 and the $n^+$ region 5, the high resistivity region 6 of the thickness l is almost depleted by the bias voltage $V_s(+)$ and the carriers in the high resistivity layer 6 transit mostly at the saturated velocity, the distribution of the holes at the co-ordinates (x, y) after t sec is given by

$$n(x, y) = n_0 e^{-\frac{(x-V_s t)^2}{4Dt} - \frac{y^2}{4Dt}} \qquad (4)$$

where $n_0$ is the total number of the holes of the initial $\delta$-function-like distribution, $V_s$ is the saturated velocity of the holes which is substantially $1 \times 10^7$ cm/sec and D is the diffusion length of the holes in the high resistivity region 6. Letting the thickness of the high resistivity region 6 be represented by l, the transit time $\tau$ of the holes in the x direction in the high resistivity region 6 is given by

$$\tau = \frac{l}{V_s} \qquad (5)$$

Accordingly, the distribution of the holes in the p—$p^-$ junction is given by

$$n(x, y) = n_0 e^{-\frac{(x-V_s \tau)^2}{4D\tau} - \frac{y^2}{4D\tau}} \qquad (6)$$

and the hole distribution in the y direction in the interface of the p—$p^-$ junction spreads only due to diffusion; therefore, combining the distributions in the positive and negative directions in the y-axis, it follows that

$$4\sqrt{D\tau} = \sqrt{D \cdot \frac{l}{V_s}} \qquad (7)$$

With $l=100\ \mu$m and $V_s(+)=10$V or so, $4\sqrt{D\tau}\dot{=}4$ $\mu$m or so; accordingly, the cell area can be designed small by that and the spatial resolution is also improved and, in addition, further large scale integration is possible. Moreover, the optical input receiving surface of the image sensor depicted in Figure 1 is made substantially flat, so that the incident light can be collected over the entire area of the cell to provide for enhanced sensitivity. Although in the present invention the cell area is made small, the output voltage per optical irradiation area is approximately

$$\frac{Q(t)}{C_f} = \frac{cq}{C_f}\int_0^t S(t)dt,$$

as described previously and the absolute value of the voltage to be read out is about $(C_S+C_B)/C_f$ times larger in terms of sensitivity than in the prior art image sensors in which the voltage read out by the carrier storage operation is obtained by the voltage division by capacitance. Accordingly, not only the spatial resolution but also the output sensitivity are essentially improved.

As is evident from the schematic circuit diagram of Figure 1B, the applied voltage $V_s(+)$ is divided by each of series-connected diodes D1 and D2 and the storage capacitance $C_s$ of the $n^+$ region 8. In the transient state immediately after the application of the voltage $V_s(+)$, the diode D1 is approximated by an electrostatic capacitance $C_i$ which is inversely proportional to the thickness $l$ of the high resistivity region. Accordingly, in order to achieve the optimum condition for applying most of the voltage $V_s(+)$ to the high resistivity region 6, it is desirable to select the thickness $l$ of the high resistivity region 6 so that $C_i<C_f,\ C_s$.

In the present invention, measures are also taken for the thermal noise which is one of the factors defining the lower limit of the dynamic range. The present invention employs such a structure and impurity concentrations that the occurrence of a dark current in the sensor proper is decreased one to two or more orders of magnitude, as compared to the conventional MOS and CCD image sensors. In Figure 1A, the region by which light is sensed is the high resistivity region 6 and the dark current of this light sensing region depends on the electrons in the p region 7 and the holes in the $n^+$ region 5 if there hardly exists in the high resistivity region 6 deep impurity levels which excite carriers. Letting the acceptor impurity concentration of the p region 7 and the donor impurity concentration of the $n^+$ region 5 be represented by $N_A$ and $N_D$, respectively, and assuming that the impurities are mostly ionized, the minority carriers in the respective regions are given by

$$n_{p0}=\frac{n_i^2}{N_A} \qquad (8)$$

$$p_{n0}=\frac{n_i^2}{N_D} \qquad (9)$$

where $n_i$ is the density of carriers which are thermally excited in an intrinsic semiconductor. By selecting the carrier density $n_i$ to be $1.6\times10^{10}$ cm$^{-3}$ at room temperature and the about donor impurity $N_D$ to be $10^{20}$ cm$^{-3}$, the number of the minority carriers $p_{n0}$ can be suppressed to about three to four. A saturated current of a $pin^+$ diode in the reverse-biased condition is approximately given by

$$J_S=(\frac{qD_pP_{n0}}{L_p} + \frac{qD_nn_{p0}}{L_n}) \cdot (\exp(-\frac{qV_J}{kT})-1)$$
$$(10)$$

Equation (10) is applicable to the case where the diffusion lengths $L_p$ and $L_n$ of holes and electrons are smaller than the thicknesses $W_n$ and $W_p$ of the $n^+$ and p regions 5 and 7, respectively. If the thicknesses $W_n$ and $W_p$ become smaller than the diffusion lengths $L_p$ and $L_n$, $L_p$ and $L_n$ in equation (10) are respectively replaced with $W_n$ and $W_p$. In equation (10), $D_p$ and $D_n$ are the diffusion constant of holes in the $n^+$ region 5 and electrons in the p region 7. When the voltage $V_J$ in equation (10) becomes large to some extent, equation (10) can be rewritten as follows:

$$J_S=\frac{qD_pP_{n0}}{L_p} + \frac{qD_nn_{p0}}{L_n}$$
$$(10')$$

or

$$J_S=\frac{qD_pP_{n0}}{W_n} + \frac{qD_nn_{p0}}{W_p}$$
$$(10'')$$

As is apparent from equations (10′) and (10″), if $P_{n0}$ and $n_{p0}$ are small, the dark current $J_s$ becomes small. In the case where the deep impurity level density in the high resistivity region 6 is sufficiently small and the generation-recombination is almost negligible, the dark current becomes as indicated by equations (10) and so on. In this case, by employing such a structure in which the $n^+$ region 5 has a sufficiently high impurity density and the p region is almost depleted to perform what is called the SIT-like operation, the amount of carriers flowing into the region 6 from the both ends thereof can be made sufficiently small, by which the dark current can be extremely reduced. At the present technological level, the dark current is mostly a generation-recombination current in the high resistivity region 6. The use of a region of extremely high purity as in the present invention enables remarked reduction of the dark current and hence is advantageous.

In the image sensor of the present invention, the upper limit of the dynamic range is determined, in principle, by the voltage $V_s(+)$ and, for instance, it reaches a voltage value exceeding $V_s(+)/2$. If the voltage of the $n^+$ region 8 is positive and too high, the field intensity in the high resistivity region decreases, resulting in a nonlinear effect. Accordingly, if the voltage $V_s$ is raised, the upper limit of the dynamic range rises by that. In the present invention, the upper limit of the dynamic range is improved at least one order of magnitude over that in the prior art. As regards the voltage spike noise resulting from the capacitance coupling, the parasitic capacitances of the readout transistor $Q_1$ and the refresh transistor $Q_2$ are reduced in connection with the sensor cell portion. Further, a low-pass filter and a video preamplifier of high sensitivity and low noise are provided in the video output port. The output sensitivity is extremely high, as described previously, because the stored voltage $V(t)$ is outputted substantially as it is without being divided by the capacitance of the output line. Furthermore, because of the non-destructive readout, the image sensor of the present invention is of extremely good image clarity in terms of both space and time. By forming the $n^+$ storage region of a material having a large forbidden band gap, the holes stored by optical excitation are prevented from flowing into the $n^+$ storage region 8, in consequence of which the linearity of response of the output to the optical input is extremely improved. In Figure 1, the readout transistor $Q_1$ is described to be an n-channel MISSIT and the refresh transistor $Q_2$ is described to be a p-channel MISSIT but these transistors $Q_1$ and $Q_2$ may also be the BJT, MOSFET or J-FET as described previously. It is preferred to employ such transistors that exhibit a linear resistance and a linear current-voltage characteristic, not such devices that exhibit a saturation characteristic which limits the current-voltage characteristic.

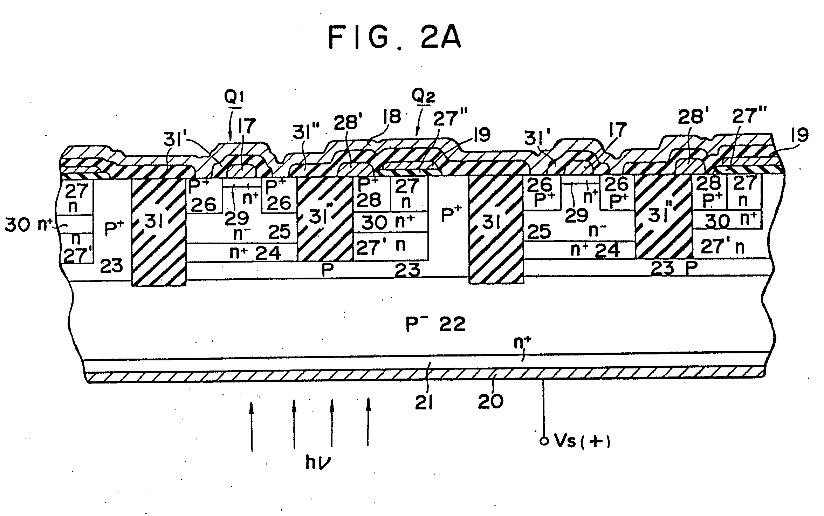

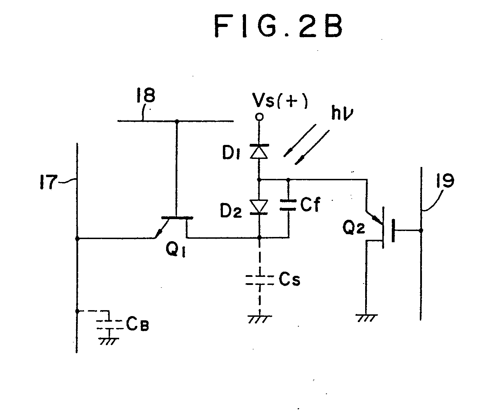

Figures 2A and 2B are respectively a sectional view an equivalent circuit showing the principal part of another embodiment of the present invention. In Figure 2, the major storage capacitance $C_s$ and the earth line are not shown, as is the case with Figure 1. In this embodiment, the readout transistor $Q_1$ is an n-channel J-SIT or JFET and the refresh transistor $Q_2$ is a p-channel MISSIT or MISFET.

Reference numeral 17 indicates a bit line connected to an $n^+$ source region 29 of the readout transistor $Q_1$, which bit line is formed of doped polysilicon or silicide of a metal such as tungsten, molybdenum or the like; 18 designates an address line connected to a $p^+$ gate region 26 of the readout transistor $Q_1$, which signal address line is formed of doped polysilicon or silicide of tungsten, molybdenum or formed by an aluminum electrode; 19 identifies a gate electrode of the refresh transistor $Q_2$, which is formed of doped polysilicon or silicide of tungsten, molybdenum or the like; 20 denotes a transparent electrode connected to the voltage source $V_s(+)$, which electrode is formed of $SnO_2$, $In_2O_3$ or polysilicon; 21 represents an $n^+$ region; 22 shows a high resistivity layer; 23 refers to a p floating region; and 24 indicates an $n^+$ floating region. The structure of Figure 2A is identical with the structure of Figure 1 in that the $n^+$ region 21 may be removed to provide hetero junction between the region 22 and the transparent electrode 20, too.

The hook structure composed of the $n^+$ region 24, p region 23, $p^-$ region 22 and the $n^-$ region 21 constitutes a light sensing structure as is the case with the embodiment of Figure 1. Reference numeral 25 indicates an $n^-$ region of an n-channel JSIT; 26 designates a $p^+$ gate of the readout transistor $Q_1$; 27 identifies a channel region of the refresh transistor $Q_2$; 28 denotes a drain of the transistor $Q_2$, which is grounded via a line 28' formed of doped polysilicon or silicide of tungsten, molybdenum or the like; 30 represents a buried layer provided for limiting a depletion layer of the channel to improve the OFF characteristic of the transistor $Q_2$ and for lessening the influence of $\alpha$ rays and the like, which buried layer need not always be provided; and 27' shows a part of the channel region 27, which is not indispensable but may be filled with an insulator or the like. Similarly, an $n^+$ region 30 may also be an insulator material layer; it is proper to use, for example, the SIMOX technique or graphoepitaxy and laser anneal technique. The region shows the gate insulating films of refresh transistor $Q_2$ and the region 27', 31' and 31'' are the insulating material regions for isolation. 31 is an isolation region.

This embodiment is fundamentally identical in operation with the embodiment of Figure 1. The thickness l of the high resistivity layer 22 and the impurity concentrations and thicknesses of the p region 23, the $n^+$ region 21 and the $n^+$ region 24 are substantially the same as those in the hook structure of the embodiment depicted in Figure 1. The impurity density of the $n^-$ region 25 is usually selected to be about $5 \times 10^{15}$ cm$^{-3}$ or less. The impurity densities are increased as the gate-to-gate spacing is increased.

It is further preferred to prevent holes stored in the p region 23 from flowing out therefrom into the $n^+$ region 24 by forming the latter of a material which has a wide energy gap, such as SIPOS, as described previously. This will improve the frequency characteristic of the hook structure with respect to light, as referred to previously.

The embodiment of Figure 2 also exels the conventional image sensors in terms of (1) dynamic range, (2) sensitivity, (3) noise and (4) image clarity. Further, this embodiment is capable of non-destructive readout and the sensitivity of the voltage appearing on the signal readout line is determined by the voltage $V(t)$ of the $n^+$ region 24, not by the capacitance division, as in the embodiment of Figure 1.

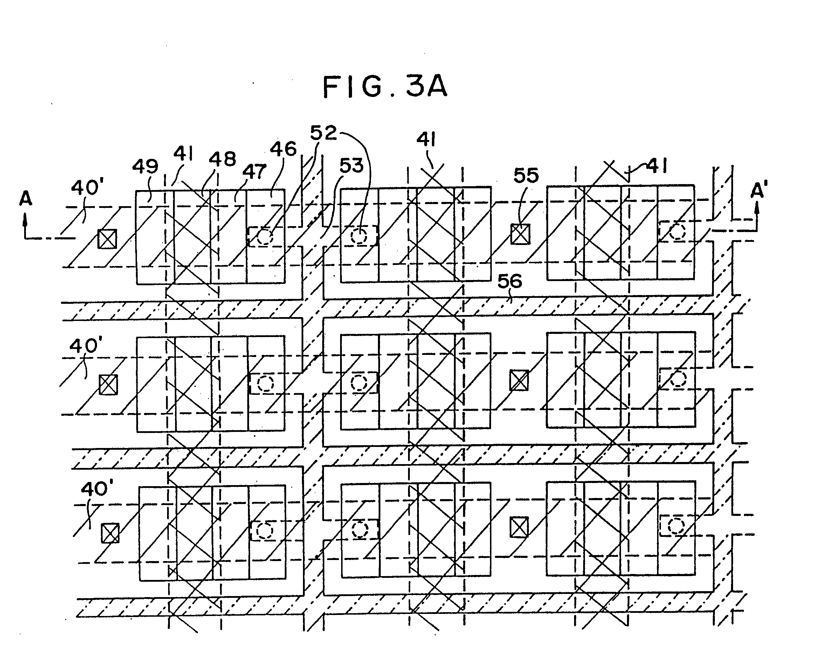

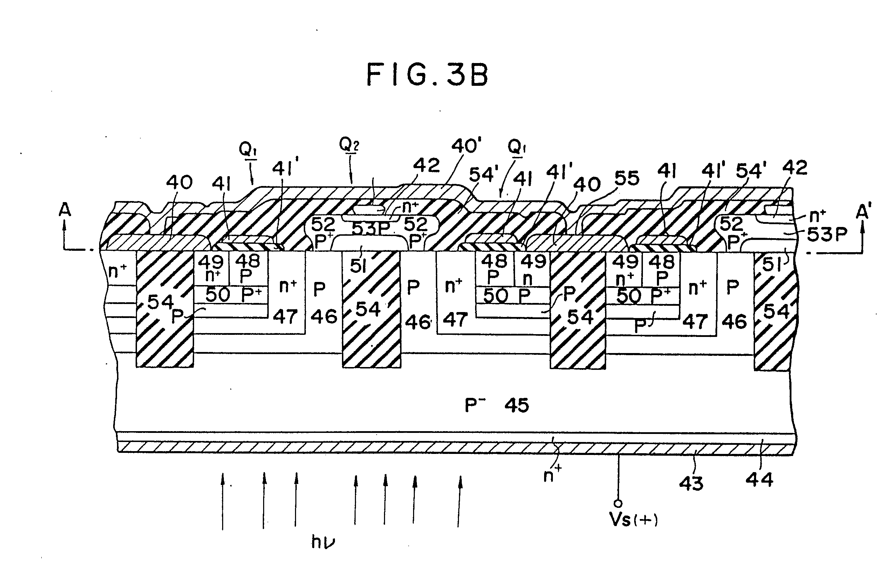

Figures 3A and 3B are respectively a plan view and a sectional view showing the principal part of another embodiment of the present invention, the major storage capacitor $C_s$ being omitted. Figure 3B is a sectional view taken on the line A—A' in Figure 3A. In the embodiments of Figures 1 and 2, the refresh transistor $Q_2$ is provided adjacent the readout transistor $Q_1$, that is, the transistors $Q_1$ and $Q_2$ are formed in pair, whereas in the embodiment of Figure 3, the refresh transistor $Q_2$ is disposed at a position higher than the readout transistor $Q_1$ and arranged so that during the refresh operation, holes stored in a p region 46 are flowed out therefrom into a $p^+$ diffusion line (an earth region 56) at a stroke (see Figure 3A).

The hook structure formed by an $n^+$ region 47, p region 46, $p^-$ region 45 and an $n^+$ region 44 indicates a transparent sensing region. Reference numeral 43 indicates a transparent electrode connected to the $n^+$ region 44, which electrode is formed of $SnO_2$, $In_2O_3$ or doped polysilicon. By forming the refresh transistor $Q_2$ in the vicinity of the surface of the substrate assembly, the packing density of the image sensor cell array is increased and the spatial resolution is also increased compared to that obtainable in the case where the refresh transistor $Q_2$ is disposed adjacent to the readout transistor $Q_1$ in the semiconductor substrate. The sensor cells are arranged substantially symmetrically with respect to a mesh-like $p^+$ earth line region 56, so that during refreshing holes stored in the respective p region 46 can be taken out in common thereto. Figure 3B clearly shows that this embodiment employs, for refreshing, a junction FET using the p floating regions 46 of adjoining cells as the drain and the source (52), an $n^+$ region 42 as the gate and a channel region 53 as the channel. This refresh transistor $Q_2$ may be a JFET formed principally of polysilicon. By forming the doped polysilicon region 52 between the channel region 53 rendered monocrystalline by laser anneal and the p region 46 on either side thereof, the source-drain region is formed. On the junction type $n^+$ gate portion 42 formed by diffusion or ion implantation a refresh line of polysilicon, $WSi_2$ or $M_0Si_2$ is wired so that the image cells on both sides thereof may be refreshed in common.

An $n^+$ region 49 is the source region of the readout transistor $Q_1$ (an n-MISSIT or MISFET). Reference numeral 48 indicates a channel; 41' designates a gate insulating film which is formed of $Si_3N_4$, $SiO_2$ or the like and on which is wired a word line 41 of silicide of a refractory metal such as tungsten, molybdenum, tantalum or the like; and 40 identifies an electrode connected to the $n^+$ region 49, which electrode is formed of doped polysilicon, $M_0Si_2$, $WSi_2$, $TaSi_2$, $TiSi_2$ or the like. The electrode 40 is common to the source region 49 of the readout transistor $Q_1$ of the adjoining image cell and the electrode 40 is connected via a contact 55 to a signal readout line 40'. The signal readout line 40' is also formed of doped polysilicon, $M_0Si_2$, $WSi_2$, $TaSi_2$, or the like.

A region 50 is provided for limiting the depth of a depletion layer in the channel region 48 to speed up the operation, for lessening the influence of $\alpha$ rays and the like and for improving the OFF characteristic in the case of the channel length being reduced, as already described with regard to the embodiments of Figures 1 and 2. A region 51 is formed of non-doped polysilicon. Of course, it may be formed of $SiO_2$, $Si_3N_4$ or the like. Regions 54 are isolation layers. The refresh transistor $Q_2$ is shown to be the JFET but may be another transistor, for example, a MOSFET or the like.

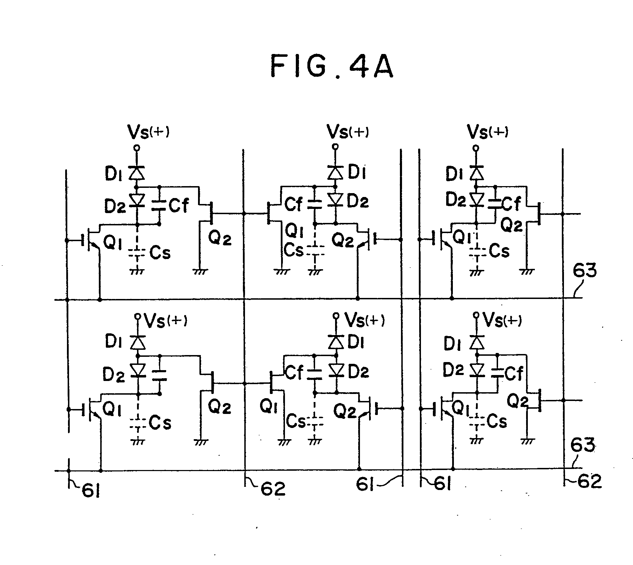

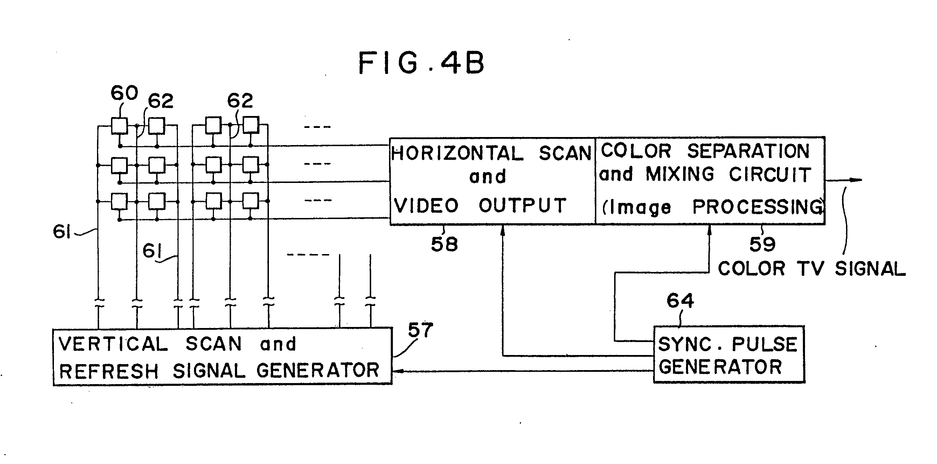

Figure 4A shows equivalent circuits of six cells of the image sensor depicted in Figures 3A and 3B. Reference numeral 61 indicates an address line; 62 designates a refresh line; and 63 identifies a signal output line. As is seen from Figure 4A, the refresh line is common to all of the cells. Figure 4B illustrates an example of the circuit arrangement of a color area image sensor system employing the image sensor cells. Reference numeral 60 indicates the individual image cells; 57 designates a vertical scan and refresh signal generator for controlling voltages of the address lines 61 and the refresh lines 62; 58 identifies a horizontal scan and video output circuit; and 59 denotes a color separation and mixing circuit (an image processing unit) which performs color separation and mixing to provide a color TV signal output. In Figure 4B, the circuit arrangement is such that signals of green (G), red (R) and blue (B) of the cells designated by color filters are taken out from the same signal readout line. 64 is a synchronisation pulse generator.

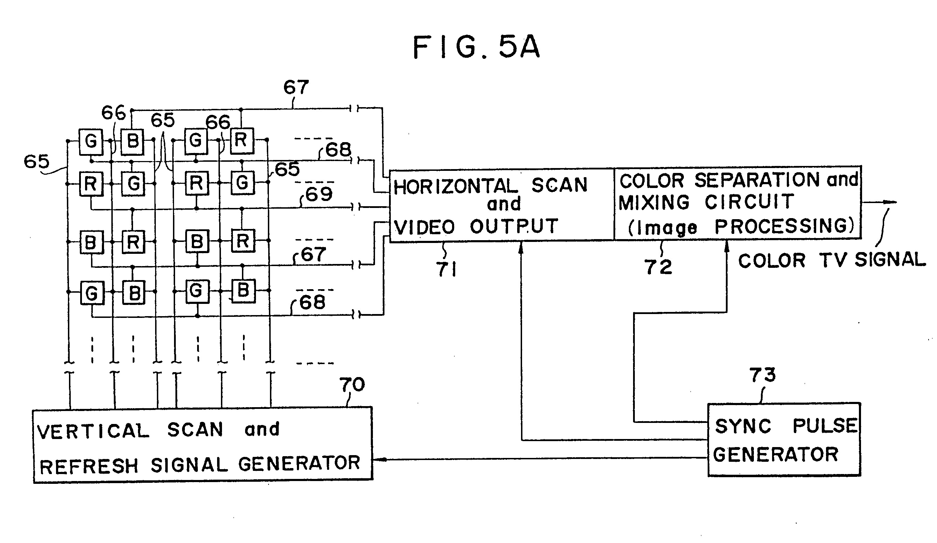

Figure 5A shows an example in which the signals G, R and B are taken out from different signal readout lines. In Figure 5A, the image cells which are designated by color filters are arranged in a checkered pattern and the signals G, B and R are outputted from different signal readout lines. Reference numeral 65 indicates signal address lines; 66 designates a refresh line; 67 identifies signal output lines for the blue (B) signal; 68 denotes signal output lines for a green (G) signal; 69 represents signal output lines for the red (R) signal; 70 shows a vertical scan and refresh signal generator; 71 refers to a horizontal scan and video output circuit; and 72 indicates an image processing unit for color separation and mixing process. These parts are synchronized by pulses from a synchronizing pulse generator 73.

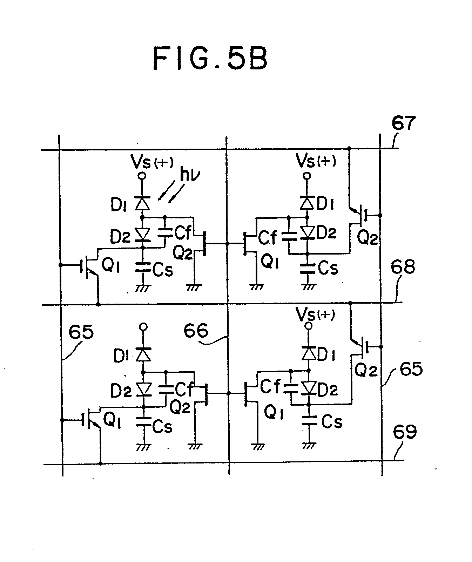

Figure 5B illustrates equivalent circuits of four of the image cells arranged the checkered pattern. A specific arrangement of the embodiment of Figure 5 is identical with the embodiment of Figure 3 except only in the connection of the readout line 40 or 40′ in the latter. That is, in the embodiment of Figure 5, the bit lines are interconnected every other image cells in the horizontal direction.

The image sensor of the present invention has such a striking feature that the voltage induced on the signal readout line hardly depends on the parasitic capacitance $C_B$ on the signal readout line, as described previously. In the image sensor of the present invention, the voltage occurring on the signal readout line ensuring the readout process is given by, $V_B(t)$ per optical irradiation area,

$$V_B(t)=V(t)=\frac{cq}{C_f}\int_0^t S(t)dt,$$

so that a decrease in the area of the image sensor cell surely causes a corresponding decrease in the junction capacitance $C_f$ of the floating pn junction, and consequently the output voltage occurring on the signal line increases by that. Conventional types of solid-state color image sensors has the shortcoming that the use of the single-plate system, instead of the three-plate one, decreases the number of picture elements per color as compared with the three-plate system, resulting in lowered resolution and sensitivity. In the prior art CCD or MOS image sensors, as described previously, the voltage to be read out is subjected to the capacitance $C_B$ of the readout line and the storage capacitance $C_S$ decreases corresponding to the decrease in the cell area and, according, the voltage to be read out becomes

$$C_B/(C_S+C_B) \cdot Q/C_S$$

where Q is the amount of stored charges. The voltage $Q/C_S$ stored in the capacitance $C_S$ is multiplied by

$$1/(1+C_B/C_S)$$

by the capacitance division and when the capacitance $C_S$ becomes, for example, $1/3 \cdot C_S$, the voltage to be read out becomes

$$1/(1+3C_S/C_S).$$

In the image sensor of the present invention the output voltage is independent of the capacitances $C_S$ and $C_B$ and is not read out by the capacitance division (the voltage V(t) of the floating $n^+$ region is outputted almost as it is, as referred to previously); accordingly, the sensitivity of the output voltage does not lower. Further, a decrease in the area of each picture element increases the spatial resolution without impairing the sensitivity. That is, in the case of employing the image sensor of the present invention as a color image sensor, there is no likelihood of lowered resolution and sensitivity caused by using the single-plate system instead of the three-plate one in the prior art. On the contrary, when the area of each picture element decreases, the output voltage increases correspondingly and the spatial resolution also rises.

Since the read-out voltage is almost independent of the earth capacitance $C_S$ of the storage region (the floating $n^+$ region) for the amount of majority carriers lacking, there is practically no need of increasing $C_S/C_B$ in the image sensor of the present invention. This introduces such a feature that the packing density can be made extremely high. Moreover, if the input light can be sufficiently collected by a lens, the sensitivity increases as the cell area decreases to reduce the junction capacitance $C_f$.

The foregoing description has been given of the back illumination type structure from the standpoint of improving the photo detecting sensitivity.

The image sensor of the present invention has the advantage that a decrease in the cell area rather increases the sensitivity. Accordingly, the image sensor of the present invention fully exhibits this advantage in the case of the front illumination type structure, too. The front illumination type structure is defective in that the effective optical irradiation surface area is reduced to introduce complexity in the wiring on the surface but advantageous in that the thickness of the semiconductor substrate need not be made small.

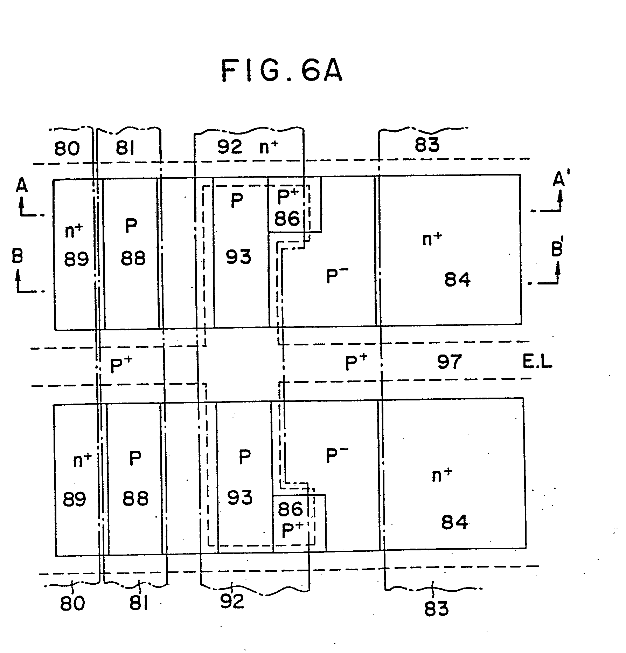

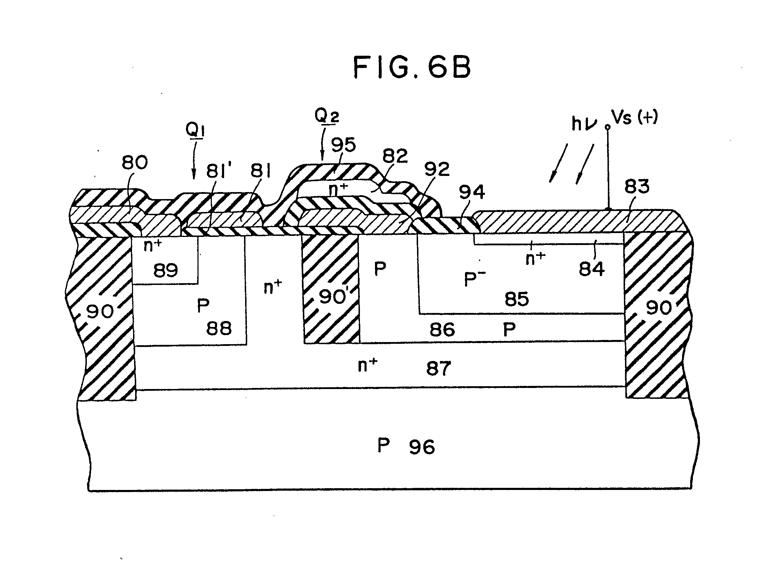

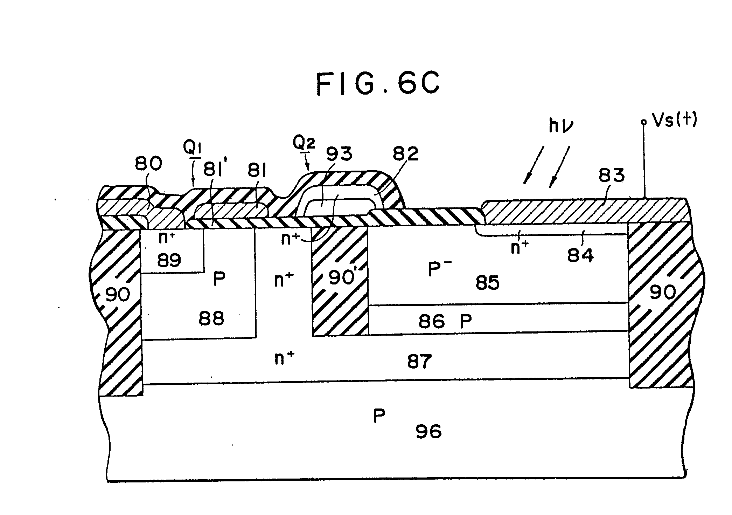

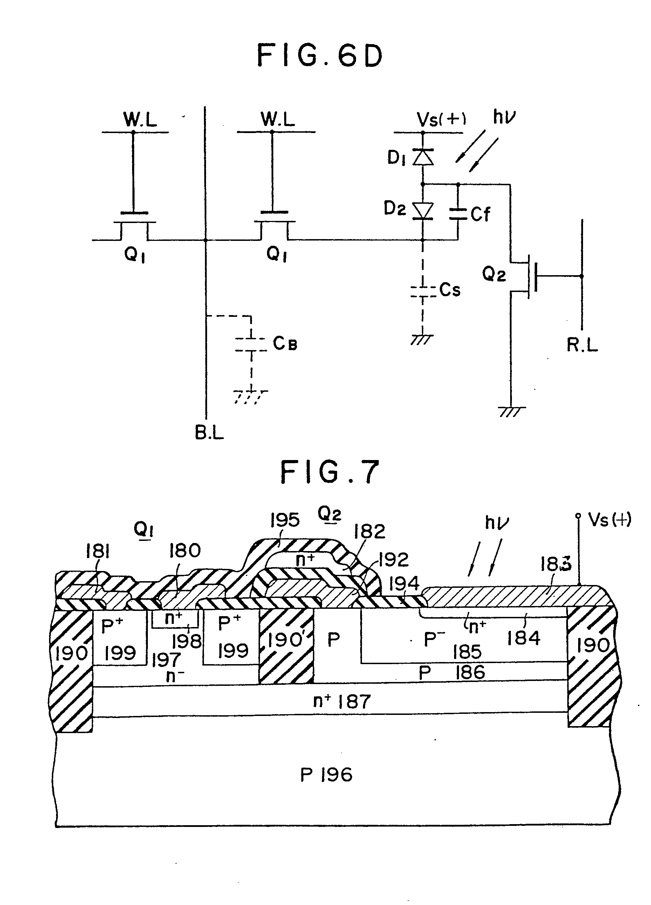

Figures 6A, B, C and D illustrate an example of the front illumination type image sensor of the present invention. Figure 6A is a plan view of the image sensor, Figure 6B a sectional view taken on the line A—A′ in Figure 6A, 6C a sectional view taken on the line B—B′ in Figure 6A and Figure 6D, a schematic circuit diagram. Also in Figure 6, the storage capacitor $C_S$ of the $n^+$ floating region 87 is omitted. The photo-sensing part is constituted by an $n^+$ region 87, a p region 86, a $p^-$ region 85, an $n^+$ region 84 and a transparent electrode 83. The transparent electrode 83 is supplied with a predetermined positive voltage $V_s(+)$ and the $p^-$ region 85 is completely depleted. The $p^-$ region 85 is exposed to a high intensity electric field; in this case, it is desirable to apply such a high intensity field that holes transit at a saturated velocity anywhere in the region 85. Reference numeral 96 indicates a p substrate. An $n^+$ region 89, a p region 88, the $n^+$ region 87, an insulating layer 81′ and a gate electrode 81 make up the readout transistor $Q_1$. The refresh transistor $Q_2$ is a JFET comprised of a $p^+$ polysilicon region 92, a p polysilicon region 93, a $p^+$ polysilicon region 97 and an $n^+$ polysilicon gate 82 (see Figures 6A, B and C). Reference numeral 80 indicates a signal readout line (B · L); 81 designates an address line (W · L): 82 identifies a refresh line (R · L); 97 denotes an earth line (E · L) (Figure 6A); 90 represents isolation regions for isolating each of cells from adjacent ones of them; and 90′ shows an isolation region for isolating the $n^+$ region 87 and a part of the p region 86 from each other, which region is not always necessary. The p region 86 may adjoin, along its entire length, the $n^+$ region 87, too. But the provision of the isolation region 90′ brings about the advantage that the capacitance $C_f$ of the p hole storing region 86 decreases to provide for increased sensitivity. Reference numerals 94 and 95 indicate insulating layers as of $SiO_2$, $Si_3N_4$ or the like. In this embodiment, since the region 86 for storing optically excited holes can be made small compared to such regions in the foregoing embodiments, the sensitivity tends to increase.

It is desirable that the $n^+$ region 84 is 0.5 $\mu$m or less in thickness and that the $p^-$ region 85 is 5 $\mu$m or less in thickness. The readout line 80 is formed of $n^+$ polysilicon, silicide such as $WSi_2$, $M_0Si_2$, $TaSi_2$ or $TiSi_2$, or a compound of them. The word line 81 is formed of $n^+$ or $p^+$ polysilicon, silicide such as $WSi_2$, $M_0Si_2$, $TaSi_2$ or $TiSi_2$ or a compound of them. The refresh line 82 is formed by an $n^+$ polysilicon region, which may be covered with silicides, as required. The earth line 97 is formed by a $p^+$ polysilicon region, which may also be covered with silicide, as required. The impurity density of the $p^-$ region 85 is approximately $1 \times 10^{15}$ cm$^{-3}$ or less and the impurity density of the p region serving as the channel of the readout transistor is around $5 \times 10^{14}$ to $5 \times 10^{16}$ cm$^{-3}$. The impurity densities of the other regions are the same as used in the foregoing embodiments. It is rather preferred that the p substrate has a lower impurity density, for example, about $5 \times 10^{15}$ cm$^{-3}$ or less. As for the polysilicon JFET for refreshing, the thickness and impurity density of the channel region 93 are about 0.3 to 2 $\mu$m and about $1 \times 10^{15}$ to $1 \times 10^{17}$ cm$^{-3}$, respectively. In the case where the $p^-$ region 85 is 4 $\mu$m thick and has an impurity density of approximately $5 \times 10^{14}$ cm$^{-3}$ or less and the voltage $V_s$ is 40 V, the electric field intensity over the entire area of the region 85 becomes substantially equal to 100 KV/cm or so and almost all holes transit at the saturated velocity.

The photo-sensing and readout operation are the same as those in the embodiments of Figures 1, 2 and 3. That is, holes excited in the $p^-$ region 85 flow into the p region 86, wherein they are stored. The p region 86 having thus stored therein the positive charges is charged positively. From the $n^+$ region 87 electrons flow out towards the $n^+$ region 84, in consequence of which the $n^+$ region 87 is also charged to a positive voltage substantially equal to that of the p region 86. This positive voltage is appeared on the signal readout line in the readout operation.

Figure 7 illustrates in section another embodiment of the front illumination type image sensor of the present invention. Also in this case, the storage capacitor $C_s$ in the $n^+$ floating region 187 is not shown. This embodiment differs from the embodiment of Figure 6 in that the readout transistor MOSFET $Q_1$ in the latter is a JSIT. The JSIT $Q_1$ is made up of an $n^+$ region 198, an $n^-$ region 197, a $p^+$ gate region 199 and $n^+$ region 187. The $p^+$ region 199 is the gate region and the $n^-$ region 197 the channel region. The $n^+$ region 198 and the $n^+$ region 187 constitute main electrodes in which currents flow. The remaining reference signs of Figure 7 minus 100 correspond to those of Figure 6. Thus, for instance substrate 196 of Figure 7 corresponds to substrate 96 of Figure 6.

The readout transistor $Q_1$ and the refresh transistor $Q_2$ may each be any of the BJT (bipolar transistor), the JFET, the MOSFET, JSIT and the MOSSIT.

Figure 8 is a sectional view illustrating another front illumination type image sensor. In Figure 8, reference numeral 284 indicates an $n^+$ surface region; 285 designates a $p^-$ high resistivity region; 286 identifies a p hole storing region; 287 denotes a region which serves as an $n^+$ excess carrier depletion region and, at the same time, serves as one of main electrode regions of the readout transistor; 288 represents a p-channel region; 289 shows the other main electrode region of the readout transistor; 290 refers to an address line; 291 indicates a signal output line; 292 and 293 designate metal regions; 294 identifies an insulating region formed between the metal regions 292 and 293. The embodiment of Figure 8 differs in construction from the embodiment of Figure 7 only in that no refresh transistor is provided. The earth capacitance $C_s$ of the sandwich structure (metal region 292-insulating region 294-metal region 293) is formed definitely. As mentioned previously, this capacitance $C_s$ is not illustrated in the foregoing embodiments. The operation of the device depicted in Figure 8 is basically identical with the operations of the devices already described; therefore, no detailed description will be repeated thereof.

A description will be given of structural improvements for increasing the performances of the image sensor of the present invention, in particular, the linearity. That is, in the present invention the photo sensing and storing portion is improved. When optically excited holes accumulate in the p region to charge it positively, electrons are injected into the p region from the floating $n^+$ region adjacent thereto and flow out from the p region into the high resistivity region, thereafter being absorbed by the electrode on the surface of the device. In this case, as referred to previously, the holes stored in the p region also tend to flow into the adjoining $n^+$ region. If the holes should flow into the $n^+$ region, then there would be lost the linearity of photo detection that the $n^+$ region is charged to a voltage proportional to the integrated value of the amount of incident light. One method for avoiding this is to form the floating $n^+$ region by a wide band gap material.

Another method is to facilitate flowing out of the electrons from the $n^+$ region but to prevent the holes of the p region from flowing into the $n^+$ region. This can be accomplished by grading the impurity distributions in the $n^+$ region and the p region. In the p region, the impurity distribution is made so that the impurity density gradually decreases as the distance from the junction between the p region and the $n^+$ region increases, whereas in the $n^+$ region, the impurity distribution is made so that the impurity density rises as the distance from the junction between the $n^+$ region and the p region increases. With such an arrangement, the electrons injected into the p regions flow into the high resistivity region, accelerated by a drift electric field, but the holes in the $n^+$ region are forced back by a decelerating electric field. The intensity E of an electric field which occurs, for example, when the impurity densities are distributed exponentially is given by

$$E = \frac{KT}{q} \cdot \frac{1}{W} \ln \frac{N_2}{N_1} \qquad (11)$$

where K is the Boltzman's constant, T temperature, $N_2$ the impurity density in the $n^+$ p junction plane, and $N_1$ the impurity density at a place spaced a distance W apart from the $n^+$ p junction plane. In the case where $N_2/N_1=100$, if $W=0.5$ $\mu$m, then $E=2.4\times10^3$V/cm at room temperature and if $W=1$ $\mu$m, then $E=1.2\times10^3$ V/cm. For example, in the $n^+$ region, the impurity density is selected to be about $1\times10^{19}$ $cm^{-3}$ in the junction plane and is increased up to $1\times10^{21}$ $cm^{-3}$ or so as the distance from the junction plane increases, and in the p region, the impurity density is selected to be approximately $1\times10^{18}$ $cm^{-3}$ in the junction plane and is decreased to about $1\times10^{16}$ $cm^{-3}$ as the distance from the junction plane increases. From the viewpoint of promoting the flow of electrons while at the same time suppressing the flow of holes as described above, it is desirable that the value of $N_2/N_1$ is selected to be about 100 or more, but the image sensor of the present invention is similarly operable even if $N_2/N_1$ does not assume the abovesaid value. It is necessary that the impurity density of the p storage region is in the range of $10^{15}$ $cm^{-3}$ and $10^{18}$ $cm^{-3}$. When this impurity density is lower than about $10^{15}$ $cm^{-3}$, the value of a built-in-potential formed between the p region and the $n^+$ region becomes too low, resulting in reducing the hook function of storing holes in the p region. If the impurity density of the p region is higher than about $10^{18}$ $cm^{-3}$, then the junction capacitance $C_f$ becomes excessively large, by which the stored voltage given by equation (1) is decreased and it becomes difficult to satisfy the condition $C_s/C_f \gtrsim 3$, lowering the readout sensitivity.

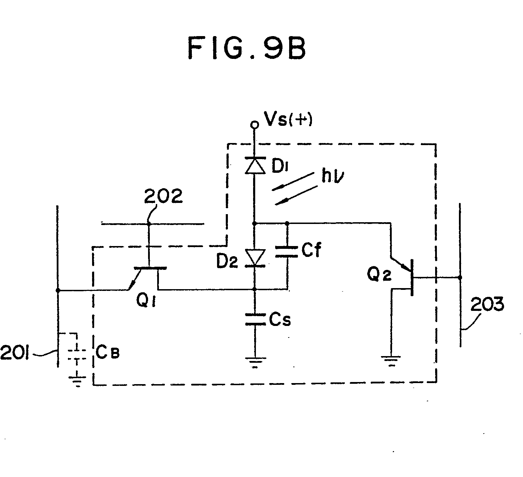

Figures 9A and 9B are respectively a sectional view showing the construction of another embodiment of the present invention and its schematic circuit diagram. A description will be given first of the outline of the arrangement of this embodiment. In Figure 9A, an $n^+$ layer 205, a $p^-$ layer 206, a p layer 207 and an $n^+$ layer 208 constitute an $n^+p^-pn^+p^+$ hook structure for optical signal detection use. In the equivalent circuit of Figure 9B this hook structure is represented by a back-to-back connection of two diodes $D_1$ and $D_2$. In Figure 9A, an $n^+$ source region 212, a $p^+$ gate region 202', a $p^-$ channel region 213 and an $n^+$ drain region 208 form a readout SIT (Static Induction Transistor), which is represented by $Q_1$ in the equivalent circuit of Figure 9B. In Figure 9A, a $p^+$ drain region 215, an $n^+$ gate region 203', a $p^-$ channel region 214 and a p source region 207 make up a refresh SIT, which is represented by $Q_2$ in the equivalent circuit of Figure 9B. The $n^+p^-pn^+p$ hook structure, the SIT $Q_1$ and the SIT $Q_2$ are formed in a single silicon substrate to constitute the cell regions of one picture element of the image sensor. The cell regions are isolated by isolation regions 211 from one another in the direction of the main surface of the substrate. As is the case with the embodiment of Figure 1, the image sensor of this embodiment is formed as the back illumination type in which optical information $h\nu$ is inputted via a transparent electrode 204 to the surface of the $n^+$ region 205 of the $n^+p^-pn^+$ hook structure.

Next, respective parts in Figure 9A will be described in detail. Reference numeral 201 indicates a signal readout line, which is connected to an electrode (formed of polysilicon, or polysilicon and a refractory metal such as molybdenum, tungsten, platinum or the like or its silicide) of the $n^+$ source region 212 of the SIT $Q_1$ formed in the silicon substrate; 202 designates an address line, which is formed by a diffused line of a $p^+$ gate 202' of the SIT $Q_1$ or a line having its resistance partly decreased by polysilicon or a high-melting-point metal; 202" identifies electrodes formed of polysilicon or a combination of polysilicon and a refractory metal (molybdenum, tungsten, platinum or the like) or its silicide; 203 denotes a refresh line, which is formed by a diffused line of an $n^+$ gate 203' of the SIT $Q_2$ or a line having its resistance partly lowered by a metal or polysilicon; 203" represents an electrode, which is formed of polysilicon or a combination of polysilicon and the refractory metal (molybdenum, tungsten, platinum or the like) or its silicide; 204 shows a transparent electrode (SnO or $In_2O_3$) for receiving the optical input, which electrode is connected to the power supply $V_s(+)$; and 205 refers to an $n^+$ diffused region, which is doped to about $10^{19}$ to $10^{21}$.

Reference numeral 206 indicates a high resistivity region, which may be a p⁻ or n⁻ region having an impurity density of about $1 \times 10^{13}$ to $1 \times 10^{14}$ cm/⁻³ or less. The relationship between the thickness l of the region 206 and the positive bias voltage $V_s(+)$ to be applied to the transparent electrode is selected to meet the requirement that the region 206 is depleted substantially over the entire area thereof. Reference numeral 207 designates a p diffused or ion-implanted region, which forms a part of the hook structure to store holes and, at the same time, serves as the source region of the p-channel SIT $Q_2$. It is preferred to minimize the thickness of the p region 207 so that holes are stored therein and electrons efficiently flow out therethrough from the n⁺ region 208 towards the high resistivity region 206. The p region 207 is formed, for example, about 0.2 to 3 $\mu$m thick. Reference numeral 208 identifies an n⁺ region adjacent the p region 207 and separated by a capacitor $C_s$ from the grounding point. When the SITs $Q_1$ and $Q_2$ are in the OFF state, the n⁺ region 208 and the p region 207 are both held in completely floating state. Reference numeral 209 denotes an oxide film or film of $Si_3N_4$ or $Ta_2O_3$ or a combination thereof, which is formed approximately 100 nm (or 20 to 100 nm) [1000 Å (or 200 to 1000 Å)] thick on a poly-silicon layer 208'; and 210 represents an earth electrode formed of aluminum or polysilicon. The polysilicon layer 208', the thin film 209 and the earth electrode 210 form the storage capacitance $C_s$. Reference numeral 211 show isolation regions, which are usually formed of $SiO_2$ and, in some cases, filled with polyimid or like insulating material; 212 refers to an n⁺ source region of the SIT $Q_1$; and 213 indicates a p⁻ channel region of the SIT $Q_1$. The SIT $Q_1$ is a device having a reverse conducting channel. The reason is that the SIT $Q_2$ is a p-channel SIT and that the layers 213 and 214 are formed concurrently.

Reference numeral 215 designates a p⁺ drain region of the p-channel SIT $Q_2$, which region is connected to the electrode 210 and held at the ground potential; 216 identifies regions formed of an oxide, nitride or like insulating material on opposing sides of the gate and drain of the p-channel SIT $Q_2$ for decreasing a parasitic capacitance therebetween; and 217 denotes regions, each formed of an insulating material on the underside of the n⁺ gate 203' opposite the source region 207 so as to decrease the parasitic capacitance between the gate and source of the SIT $Q_2$ as is the case with the regions 216. The regions 217 can be formed by the ion implantation of $O_2$, $N_2$ or the like using the SIMOX (Separation by Insulated Oxygen) technique. Regions 218 and 219 are also insulator regions formed for the same purpose as the regions 216 and 217. Such a process is necessary when the best mode is effected, in particular, for decreasing the capacitance coupling noise in the image sensor. It is a matter of course that the insulating material regions 216, 217, 218 and 219 need not be provided when the operating characteristics may be deteriorated. By introducing similar insulating regions in SITs of an operational amplifier, a vertical and a horizontal scan circuit, a video output port of peripheral circuits, too noise reduction can be achieved.

The operation of the embodiment shown in Figures 9A and 9B is basically identical with the operations of the foregoing embodiments; therefore, no detailed description will be repeated.

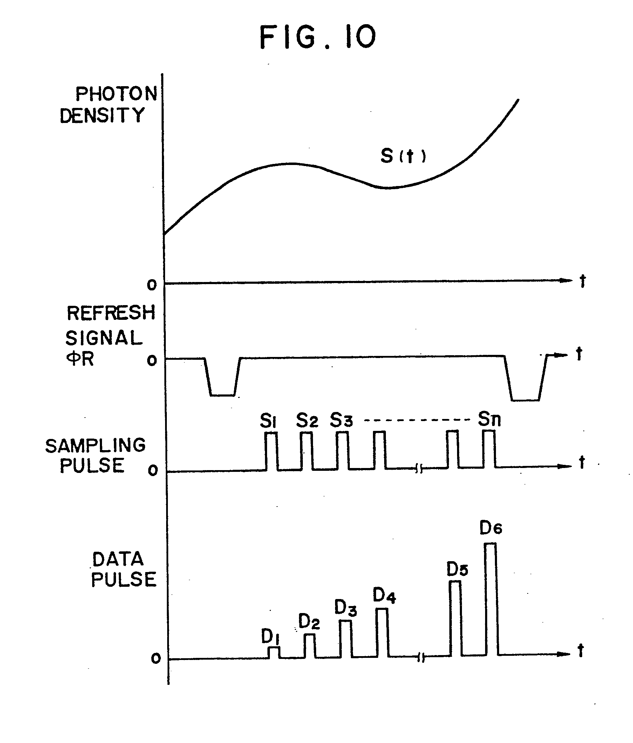

Figure 10 shows waveforms explanatory of an example of the operation mode of the image sensor according to the present invention, the abscissa representing time and the ordinate an incident photon density S(t), a refresh signal $\phi_R$ on the refresh line, sampling pulses $S_1$, $S_2$, $S_3$,...$S_n$ on the address line and data pulses $D_1$, $D_2$, $D_3$,...$D_n$ on the output signal line. Applying the sampling pulses $S_1$, $S_2$, $S_3$,...$S_n$ to the gate of the readout transistor after conducting the refresh transistor by the refresh signal $\phi_R$ and extinguishing excess holes stored in the floating p region, there are read out on the signal output line the data outputs $D_1$, $D_2$, $D_3$,...$D_n$ of magnitudes proportional to the integrated values of optical signals inputted after the refresh.

Equation (1) is an approximate expression in the state in which a certain amount of holes has been accumulated in the floating p region of the pn junction forming the hook structure a sufficiently long period of time after the start of optical irradiation of a fixed light level and the voltage V(t) of the floating n⁺ region has come to increase in proportion to time. Figure 11 shows, based on a more detailed analysis, the transient state leading to the abovesaid state. In Figure 11, the abscissa represents time after the start of optical irradiation and the ordinate the voltage $V_p(t)$ of the floating p region (indicated by broken lines) and the voltage $V_n(t)$ of the floating n⁺ region (indicated by solid lines). This analysis is made in connection with the case where the impurity density distributions of the floating n⁺ region and the floating p region are uniform and $1 \times 10^{20}$ cm⁻³ and $1 \times 10^{15}$ cm⁻³, respectively; the thickness of the floating p region is 0.5 $\mu$m; and the junction area is $10^{-6}$ cm², consequently the junction capacitance $C_f$ is 0.01 pF, and $C_s$ is 0.1 pF.

The time $t_c$ necessary for the voltage $V_n(t)$ of the floating n⁺ region to get sufficiently close to the voltage of the floating p region depends on the structure of the floating pn junction and the irradiated light level. Accordingly, the moment for recording a still picture, that is, the moment of shutter release is selected to be the moment when a period of time longer than the time $t_c$ has lapsed after the start of the optical irradiation or turning OFF of the refresh transistor. The time $t_c$ decreases as the thickness of the floating p region decreases, as the impurity density gradient in the floating p region becomes steep and as the irradiated light level increases. For example, in the embodiment of Figure 1A, in the case where the impurity density and its distribution in the floating p region are a constant-density distribution of $10^{15}$ cm$^{-3}$, the thickness of the region is 0.5 $\mu$m and $C_s/C_f$ is 10, if the irradiated light level is 10 luxes, then the time $t_c$ is 1.1 msec. In the above case, if the impurity density is graded so that it decreases about three orders of magnitude as the distance from the floating pn junction plane increases, then the time $t_c$ is reduced down to 0.88 msec. On the other hand, when the optical input has a light level of 1 lux, the time $t_c$ is 8.6 and 5.6 msec in the two cases, respectively. These characteristics proved to be the same in the other embodiments.

Although in the foregoing embodiments no mention is made of a matching multi-layer film which improves the matching for the incidence of light, for example, on silicon, it is a matter of course to provide the multi-layer film on the optical input receiving surface for raising the light detecting sensitivity. Further, in the case of providing a color detection, cells of blue, green and red, for example, are arranged in a checkered pattern but, in this case, color filters are provided on each cell.

For detecting a light having a wavelength longer than 1 $\mu$m, a material responsive to long wavelength light, such as Hg$_x$Cd$_{1-x}$Te or the like is grown heterogeneously or deposited by the CVD method, sputtering or evaporation on the surface of the photo detecting portion of silicon. Since a high intensity electric field is applied to this region, excited carriers rapidly flow into the storage region; therefore, the light detecting sensitivity does not much depend on the quality of material used for this region. In the case of detecting lights of shorter wavelengths than purple, a material of large energy gap, such as ZnSe or the like is coated to a predetermined thickness on the light detecting portion. While the foregoing description has been given of the case of using light as a source of radiant energy, it may be replaced with X-rays, electron rays or the like so long as it generates electron-hole pairs in the image sensor.

It is a matter of course that the image sensor of the present invention is not limited specifically to the foregoing embodiments. The smaller the electrostatic capacitance $C_f$ of an excessive majority carrier storage region is, the more the readout sensitivity increases. The readout voltage is hardly dependent on the magnitude of the electrostatic capacitance $C_s$ of a storage region for the amount of majority carrier lacking. In order to prevent that the majority carriers stored in the excess majority carrier storage region flow into the storage region for the amount of majority carrier lacking, it is extremely effective to make the impurity density of the latter lower than that of the former or to gradually increase the impurity density of the latter as the distance from the junction plane therebetween increases. The readout transistor Q$_1$ and the refresh transistor Q$_2$ are operable no matter which one of the JSIT, MOSSIT, JFET, MOSFET and BJT is used. The storage region for the amount of majority carriers lacking forms one of the two main electrode regions of the readout transistor and the excess majority carrier storage region the other. Since the sensitivity rises with a decrease in the electrostatic capacitance $C_f$ of the excess majority carrier storage region, the cell area can be reduced; especially in the structure in which the refresh transistor is formed as a polysilicon JFET or polysilicon MOSFET on the main surface of the semiconductor substrate, the cell area can be made extremely small. This is true especially in the case of the back illumination type. At least the present-day technical level, it is easy to reduce the cell area down to $10 \times 10$ $\mu$m$^2$ or less. Accordingly, the area of a cell array having $500 \times 500$ picture elements can be decreased to $5 \times 5$ mm$^2$ or less for monochrome display and $9 \times 9$ mm$^2$ or less for color display. Even if the peripheral portion is included, the area of the cell array is $7 \times 7$ mm$^2$ or less for monochrome display or $11 \times 11$ mm$^2$ or less for color display.

While the foregoing embodiments of the present invention have been described in connection with the case where holes excited in the light detecting region are stored in an excess majority carrier storage region (a p region in this case) and electrons are flowed out from a storage region for the amount of majority carrier lacking (an n$^+$ region in this case), it is a matter of course that the conductivity types of the regions can be reversed. The thin, high impurity density region formed on the surface of the light detecting portion and serving as an electrode region is not necessarily called for and the provision of the Schottky junction with the transparent electrode would rather increase the photo detecting sensitivity to short-wavelength lights such as blue and purple. In the case where a high impurity density is called for on the surface of the light detecting portion at any cost, it is sufficient, of course, to form only one layer of a high impurity density region of a larger energy gap than the silicon substrate, preferably, a high impurity density region of an indirect transition type material. The incident light is hardly absorbed by this impurity density region but it is absorbed by the high resistivity region. At any rate, the present invention permits very diversified modifications of the structure and is of great industrial utility because of excellent performances and a wide application. The image sensor of the present invention is applicable to the detection of a color or monochrome video signal, that is, to movie cameras and, by making positive use of the feature of the non-destructive readout, it can be very effectively used for the detection of a color or monochrome still picture, that is, for still cameras, as described in the foregoing. Accordingly, the image sensor of the present invention has a wide application.

The image sensor of the present invention can be fabricated through the use of the conventionally known crystal growth, diffusion, ion implantation, wet and dry etching, CVD and lithography techniques.

The impurity densities in the hook structure, their distribution profiles, materials of layers of the hook structure and their thicknesses are so selected as to optimize the carrier storage function of the hook structure, thereby permitting the non-destructive readout of the optical information. The ratio between the junction capacitance and the earth capacitance of a floating pn junction establishing a potential barrier in the hook structure is selected so that a stored voltage in the floating pn junction and threadout sensitivity may become maximum. By repeating the non-destructive readout, an integrated value of the quantity of incident light is read out. The time interval to a first operation of the readout transistor after the operation of the refresh transistor is selected in accordance with the quantity of the incident light, by which an electric signal proportional to the quantity of the incident light can be read out.

## Claims

1. A semiconductor image sensor, comprising a radiant energy input information detecting hook structure consisting of first to fourth regions (5, 6, 7, 8) formed in a semiconductor substrate from a main surface thereof towards the inside thereof, the first region being a conductive region for receiving radiant energy, the second region (6) having a high resistivity, the third region (7) being of a first conductivity type, and having a low resistivity and the fourth region (8) being of a second conductivity type, reverse from the first conductivity type and having a low resistivity, said image sensor further comprising a readout transistor $(Q_1)$ and a refresh transistor $(Q_2)$, the readout transistor $(Q_1)$ using the fourth region of one of its main electrodes, and the refresh transistor $(Q_2)$ using the third region as one of its main electrodes, characterised in that the third region (7; 23; 46; 86; 186; 207) has an impurity density in the range of about $10^{15}$ to $10^{18}$ cm$^{-3}$ and a thickness in the range of about 0.2 $\mu$m to 3 $\mu$m, and that the fourth region (8; 24; 47; 87; 187; 208) has an earth capacitance larger than a junction capacitance of a pn junction formed between the fourth region and the third region.

2. A semiconductor image sensor according to Claim 1, wherein the fourth region has an impurity density more than 100 times higher than the third region.

3. A semiconductor image sensor according to Claim 1, wherein the third region has an impurity density distribution which is graded so that the impurity density decreases as the distance from the interface with the fourth region increases.

4. A semiconductor image sensor according to Claim 1, wherein the fourth region has an impurity density distribution which is graded so that the impurity density increases as the distance from the interface with the third region increases.

5. A semiconductor image sensor according to Claim 1, wherein the fourth region is formed of a semiconductor material having a larger energy gap than a semiconductor material for the third region.

6. A semiconductor image sensor according to any one of the preceding claims, wherein the first region is a transparent electrode which permits the passage therethrough of the input radiant energy.

7. A semiconductor image sensor according to Claim 6, wherein the transparent electrode is formed of a semiconductor material having a smaller energy gap than that of a semiconductor material for the second region.

8. A semiconductor image sensor according to any one of Claims 1 to 6, wherein the first region is a metal electrode disposed so that it does not substantially intercept the input radiant energy.

9. A semiconductor image sensor according to any one of Claims 1 to 6, wherein the first region is composed of electrode means and a low resistivity semiconductor region of the second conductivity type formed between the electrode means and the second region.

10. A semiconductor image sensor according to any preceding claim wherein said earth capacitance is more than three times larger than said junction capacitance.

11. A semiconductor image sensor according to any preceding claim, wherein said junction capacitance of the pn junction is larger than the capacitance of an equivalent capacitor formed by the first region, the second region and the low resistivity third region.

12. A method of operating a semiconductor image sensor according to Claim 1, wherein the readout transistor is rendered conductive a plurality of times in the time interval between a conductive state of the refresh transistor and the next conductive state thereof, whereby the time integrated value of the input radiant energy is read out.

## Patentansprüche

1. Halbleiter-Bildsensor, enthaltend eine Strahlungsenergie als Eingangsinformation erkennende Hakenstruktur, welche aus ersten bis vierten Regionen (5, 6, 7, 8) besteht, die in einem Halbleitersubstrat von einer Hauptfläche des Halbleitersubstrats bis zu dessen Innseite gebildet ist, wobei die erste Region eine leitfähige Region zum Empfang von Strahlungsenergie ist, die zweite Region (6) einen hohen spezifischen Widerstand aufweist, die dritte Region (7) von einem ersten Leitfähigkeitstyp ist und einen niedrigen spezifischen Widerstand aufweist und die vierte Region (8) von einem gegenüber dem ersten Leitfähigkeitstyp umgekehrten zweiten Leitfähigkeitstyp ist und einen niedrigen spezifischen Widerstand aufweist, sowie ferner einen Ausgabetransistor ($Q_1$) und einen Aufladetransistor ($Q_2$), wobei der Ausgabetransistor ($Q_1$) die vierte Region als eine seiner Hauptelektroden benutzt und der Aufladetransistor ($Q_2$) die dritte Region als eine seiner Hauptelektroden benutzt, dadurch gekennzeichnet, daß die dritte Region (7; 23; 46; 86; 186; 207) eine Verunreinigungsdichte im Bereich von etwa $10^{15}$ bis $10^{18}$ cm$^{-3}$ und eine Dicke im Bereich von etwa 0,2 $\mu$m bis 0,3 $\mu$m aufweist und daß der vierte Bereich (8; 24; 47; 87; 187; 208) eine Erdkapazität aufweist, die größer ist als eine Übergangskapazität eines pn-Übergangs, der zwischen der vierten Region und der dritten Region gebildet ist.

2. Halbleiter-Bildsensor nach Anspruch 1, bei welchem die vierte Region eine verunreinigungsdichte von mehr als 100 mal größer als die dritte Region aufweist.

3. Halbleiter-Bildsensor nach Anspruch 1, bei welchem die dritte Region eine Verunreinigungsdichte-Verteilung aufweist, die derart verläuft, daß die Verunreinigungsdichte sich mit zunehmendem Abstand von der Übergangsstelle zur vierten Region verringert.

4. Halbleiter-Bildsensor nach Anspruch 1, bei welchem die vierte Region eine Verunreinigungsdichte-Verteilung aufweist, die derart verläuft, daß die Verunreinigungsdichte sich mit zunehmenden Abstand von der Übergangsstelle zur dritten Region vergrößert.

5. Halbleiter-Bildsensor nach Anspruch 1, bei welchem die vierte Region aus einem Halbleitermaterial gebildet ist, das eine größere Energielücke hat als das Halbleitermaterial für die dritte Region.

6. Halbleiter-Bildsensor nach einem der vorhergehenden Ansprüche, bei welchem die erste Region eine transparente Elektrode ist, die den Durchgang der Eingangsstrahlungsenergie zuläßt.

7. Halbleiter-Bildsensor nach Anspruch 6, bei welchem die transparente Elektrode aus einem Halbleitermaterial gebildet ist, das eine kleinere Energielücke hat als diejenige eines Halbleitermaterials für die zweite Region.

8. Halbleiter-Bildsensor nach einem der Ansprüche 1 bis 6, bei dem die erste Region eine Metallelektrode ist, die so angeordnet ist, daß sie die Eingangsstrahlungsenergie nicht wesentlich abfängt.

9. Halbleiter-Bildsensor nach einem der Ansprüche 1 bis 6, bei welchem die erste Region aus einem Elektrodenmittel besteht und zwischen dem Elektrodenmittel und der zweiten Region eine Halbleiterregion vom zweiten Leitfähigkeitstyp mit niedrigem spezifischen Widerstand gebildet ist.

10. Halbleiter-Bildsensor nach einem der vorhergehenden Ansprüche, bei welchem die genannte Erdkapazität mehr als dreimal größer ist als die Übergangskapazität.

11. Halbleiter-Bildsensor nach einem der vorhergehenden Ansprüche, bei welchem die genannte Übergangskapazität des pn-Übergangs größer ist als die Kapazität eines äquivalenten Kondensators, der durch die erste Region, die zweite Region und die dritte Region mit niedrigem spezifischen Widerstand gebildet wird.

12. Verfahren zum Betrieb eines Halbleiter-Bildsensors nach Anspruch 1, bei welchem der Ausgabetransistor in dem Zeitintervall zwischen einem leitfähigen Zustand des Aufladetransistors und dem nächsten leitfähigen Zustand dieses Ausgabetransistors mehrere Male leitfähig gemacht wird, wodurch der über die Zeit integrierte Wert der Einganstrahlungsenergie ausgelesen wird.

**Revendications**

1. Capteur d'images à semi-conducteurs, comprenant une structure hook de détection d'informations d'entrée d'énergie rayonnante consistant en une première à une quatrième régions (5, 6, 7, 8) formées dans un substrat semi-conducteur à partir de sa surface principale vers son intérieur, la première région étant une région conductrice pour recevoir de l'énergie rayonnante, la seconde région (6) ayant une haute résistivité, la troisième région (7) étant d'un premier type de conductivité et ayant une faible résistivité et la quatrième région (8) étant d'un second type de conductivité inverse du premier type de conductivité et ayant une faible résistivité, ledit capteur d'images comprenant en outre un transistor de lecture ($Q_1$) et un transistor de régénération ($Q_2$), le transistor de lecture ($Q_1$) utilisant la quatrième région comme l'une de ses électrodes principales et le transistor de régénération ($Q_2$) utilisant la troisième région comme l'une de ses électrodes principales, caractérisé en ce que la troisième région (7; 23; 46; 86; 186; 207) a une densité d'impuretés dans la plage d'environ $10^{15}$ à $10^{18}$ cm$^{-3}$ et une épaisseur dans la plage d'environ 0,2 $\mu$m à 3 $\mu$m et en ce que la quatrième région (8; 24; 47; 87; 187; 208) a une capacité à la masse supérieure à la capacité de jonction d'une jonction PN formée entre la quatrième région et la trosième région.

2. Capteur d'images à semi-conducteurs selon la revendication 1, dans lequel la quatrième région a une densité d'impuretés plus de 100 fois supérieure à la troisième région.

3. Capteur d'images à semi-conducteurs selon la revendication 1, dans lequel la troisième région a une distribution de densité d'impuretés qui varie de manière que la densité d'impuretés diminue quand la distance depuis l'interface avec la quatrième région augmente.

4. Capteur d'images à semi-conducteurs selon la revendication 1, dans lequel la quatrième région a une distribution de densité d'impuretés qui varie de manière que la densité d'impuretés augmente quand la distance depuis l'interface avec la troisième région augmente.

5. Capteur d'images à semi-conducteurs selon la revendication 1, dans lequel la quatrième région est formée d'une matière semi-conductrice ayant un plus grand intervalle d'énergie qu'une matière semi-conductrice pour la troisième région.

6. Capteur d'images à semi-conducteurs selon l'une quelconque des revendications précédentes, dans lequel la première région est une électrode transparente qui peut être traversée par l'énergie de rayonnement d'entrée.

7. Capteur d'images à semi-conducteurs selon la revendication 6, dans lequel l'électrode transparente est formée d'une matière semi-conductrice ayant un intervalle d'énergie plus petit que celui d'une matière semi-conductrice pour la seconde région.

8. Capteur d'images à semi-conducteurs selon l'une quelconque des revendications 1 à 6, dans lequel la première région est une électrode en métal disposée de manière à ne pas intercepter substantiellement l'énergie rayonnante de l'entrée.

9. Capteur d'images à semi-conducteurs selon l'une quelconque des revendications 1 à 6, dans lequel la première région est faite d'une électrode avec une région semi-conductrice de faible résistivité du second type de conductivité formée entre l'électrode et la seconde région.

10. Capteur d'images à semi-conducteurs selon l'une quelconque des revendications précédentes, dans lequel ladite capacité à la masse est plus de trois fois supérieure à ladite capacité de jonction.

11. Capteur d'images à semi-conducteurs selon l'une quelconque des revendications précédentes, dans lequel ladite capacité de jonction de la jonction PN est supérieure à la capacité d'un condensateur équivalent formé par la prelière région, la seconde région et la troisième region de faible résistivité.

12. Procédé d'utilisation d'un capteur d'images à semi-conducteurs selon la revendication 1, dans lequel le transistor de lecture est rendu conducteur plusieurs fois dans l'intervalle de temps entre un état conducteur du transistor de régénération et son état conducteur suivant, de manière que la valeur intégrée dans le temps de l'énergie rayonnante d'entrée soit lue.

# FIG. IA

0038697

# FIG.IB

# FIG.IE

# FIG. IC

Cs/Cf = 10 ,

S =
10³
10²
10
1

Vp – Vout (V)

Cʙ/Cs

# FIG. ID

S=
10³
10²
10
1

Vp – Vn (V)

Cs/Cf

# FIG. 2A

# FIG. 2B

# FIG. 3A

FIG. 3B

# FIG.4A

# FIG.4B

VERTICAL SCAN and REFRESH SIGNAL GENERATOR 57

HORIZONTAL SCAN and VIDEO OUTPUT 58

COLOR SEPARATION and MIXING CIRCUIT (Image PROCESSING 59

COLOR TV SIGNAL

SYNC. PULSE GENERATOR 64

# FIG. 5A

VERTICAL SCAN and REFRESH SIGNAL GENERATOR

HORIZONTAL SCAN and VIDEO OUTPUT

COLOR SEPARATION and MIXING CIRCUIT (Image PROCESSING)

SYNC PULSE GENERATOR

COLOR TV SIGNAL

# FIG.5B

# FIG. 6A

# FIG. 6B

FIG.6C

# FIG. 6D

# FIG. 7

# FIG. 8

# FIG. 9A

# FIG. 9B

# FIG. 10

# FIG.11